# EUROPEAN PATENT APPLICATION

(11) **EP 4 509 924 A2**
(43) Date of publication of application: **19.02.2025**
(21) Application number: 24190534.8
(22) Date of filing: 24.07.2024
(51) Int. Cl.: G03F 7/09

(54) **METHOD FOR PERFORMING RESIST UNDERLAYER FILM AND PATTERNING PROCESS**

(30) Priority: 16.08.2023 JP 2023132687
(71) Applicant: Shin-Etsu Chemical Co., Ltd., Tokyo 100-0005 (JP)
(72) Inventor: Kobayashi, Naoki, Niigata (JP); Ishiwata, Kenta, Niigata (JP); Kori, Daisuke, Niigata (JP); Yano, Toshiharu, Niigata (JP)
(74) Representative: Sonnenhauser, Thomas Martin

(57) **Abstract**

The present invention provides a method for forming by plasma irradiation a resist underlayer film with excellent dry etching resistance and film thickness uniformity, the method including: (i) applying a composition containing (A) a polymer and (B) an organic solvent, and performing heat treatment; and (ii) forming a resist underlayer film by plasma irradiation, where the polymer (A) contains a constitutional unit of formula (1) and has a weight-average molecular weight of 2,500 to 20,000: 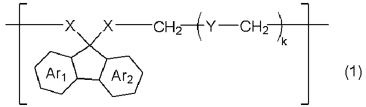 where Ar₁ and Ar₂ represent a benzene ring or naphthalene ring, X represents a structure of formula (1A), Y represents an organic group, "k" represents 0 or 1, 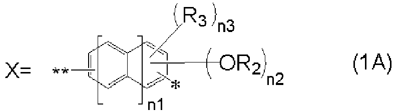 where "n₁" represents 0 or 1, "n₂" represents 1 or 2, R₂ represents a hydrogen atom, an organic group, or a structure of formula (1B), R₃ represents a hydrogen atom, an alkyl group, an aryl group, or a group of formula (1C), "n₃" represents 0 to 2, 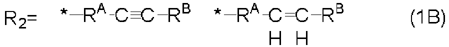 where R^{A} represents an organic group, R^{B} represents a hydrogen atom or an organic group, and 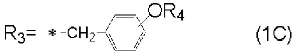 where R₄ represents a hydrogen atom or hydrocarbon group.

## Description

### TECHNICAL FIELD

The present invention relates to: a method for forming a resist underlayer film usable for fine patterning according to a multilayer resist method in a semiconductor device manufacturing process; and a patterning process using the resist underlayer film.

### BACKGROUND ART

Along with high integration and high processing speed of LSI, miniaturization of pattern size is rapidly advancing. Along with the miniaturization, lithography technology has achieved a fine patterning by shortening wavelength of a light source and selecting an appropriate resist composition accordingly. The composition mainly used is a positive photoresist composition for monolayer. The monolayer positive photoresist composition not only allows a resist resin to have a skeleton having etching resistance against dry etching with chlorine- or fluorine-based gas plasma, but also provides a switching mechanism that makes an exposed part soluble, thereby dissolving the exposed part to form a pattern and processing a substrate to be processed by dry etching while using the remaining resist pattern as an etching mask.

However, when the pattern becomes finer, that is, the pattern width is reduced without changing the thickness of the photoresist film to be used, resolution performance of the photoresist film is lowered. In addition, pattern development of the photoresist film with a developer excessively increases a so-called aspect ratio of the pattern, resulting in pattern collapse. Therefore, the photoresist film has been thinned along with the miniaturization of the pattern.

On the other hand, a substrate to be processed has been generally processed by dry etching while using a pattern-formed photoresist film as an etching mask. In practice, however, there is no dry etching method capable of providing an absolute etching selectivity between the photoresist film and the substrate to be processed. The photoresist film is thus also damaged and collapses during processing of the substrate, and the resist pattern cannot be accurately transferred to the substrate to be processed. Accordingly, higher dry etching resistance has been required in a resist composition along with the miniaturization of the pattern. However, on the other hand, a resin used for the photoresist composition needs to have low light absorption at exposure wavelength in order to improve the resolution. For this reason, the resin has shifted to a novolak resin, polyhydroxystyrene, and a resin having an aliphatic polycyclic skeleton as the exposure light shifted from i-line to KrF and ArF, which have shorter wavelength. However, this shift has actually accelerated an etching rate under dry etching conditions for processing the substrate, and recent photoresist compositions having high resolution rather tend to have low etching resistance.

As a result, the substrate to be processed has to be dry etched with a thinner photoresist film having lower etching resistance. Therefore, a demand for finding a composition used in this processing and the process therefor has become urgent.

A multilayer resist method is one of the solutions for the above problems. This method is as follows: a resist middle layer film having a different etching selectivity from a photoresist film (i.e., a resist upper layer film) is placed between the resist upper layer film and a substrate to be processed; a pattern is formed in the resist upper layer film; the pattern is transferred to the resist middle layer film by dry etching while using the resist upper layer film pattern as a dry etching mask; and the pattern is further transferred to the substrate to be processed by dry etching while using the resist middle layer film as a dry etching mask.

One of the multilayer resist methods is a three-layer resist method, which can be performed with a typical resist composition used in the monolayer resist method. For example, this three-layer resist method includes the following steps: an organic film containing a novolak resin or the like is formed as a resist underlayer film on a substrate to be processed; a silicon-containing resist middle layer film is formed thereon as a resist middle layer film; and a usual organic photoresist film is formed thereon as a resist upper layer film. Since the organic resist upper layer film ensures an excellent etching selectivity ratio relative to the silicon-containing resist middle layer film when dry etching is performed with fluorine-based gas plasma, the resist upper layer film pattern can be transferred to the silicon-containing resist middle layer film by dry etching with fluorine-based gas plasma. This method allows the pattern to be transferred to the silicon-containing resist middle layer film (resist middle layer film) even by using a resist composition with which it is difficult to form a pattern having a sufficient film thickness for directly processing the substrate to be processed or a resist composition that has insufficient dry etching resistance for processing the substrate. Then, further performing dry etching with oxygen gas plasma or hydrogen gas plasma allows the pattern to be transferred to the organic film (resist underlayer film) containing a novolak resin or the like, which has a sufficient dry etching resistance for processing the substrate. As to the resist underlayer film, many materials are already known as disclosed in Patent Document 1.

On the other hand, in recent years, with the rapid miniaturization of DRAM memory, there is a growing need for further improvement in dry etching resistance, as well as a need for a resist underlayer film having excellent filling and planarizing properties. As a coating-type organic underlayer film composition excellent in filling and planarizing properties, for example, the composition disclosed in Patent Document 2 has been reported. However, in view of application of this composition in the advanced generation, there is a concern about dry etching resistance. The application limit of the previously-known coating-type organic underlayer film compositions is thus approaching.

To solve the above problems, Patent Document 3 reports that etching resistance at the time of substrate processing can be improved by an additional treatment of irradiating the resist underlayer film with plasma or an electron beam. It is thought that by performing the additional treatment, chemical bonds of the hydrocarbon-containing film are dissociated and recombined to reconstruct a cured film having a diamond-like carbon structure, and that this contributes to increase in hardness and density. However, the resist underlayer films used in the Examples undergo a great change in film thickness of 100 nm or more due to the additional treatment, and the film thickness uniformity after the additional treatment is also expected to be insufficient. When the resist underlayer films are used as filling films of stepped substrates to be processed, the possibility that flatness may be degraded by the effect of film shrinkage caused by plasma irradiation and electron beam irradiation and the possibility that voids may be generated in the filling film due to solid components in the film being excessively dispersed in the course of the plasma irradiation and the electron beam irradiation can be considered. For this reason, it is thought that a method for forming a resist underlayer film that undergoes little change in film thickness between before and after plasma irradiation is needed.

### CITATION LIST

### PATENT LITERATURE

Patent Document 1: JP2004-205685A
Patent Document 2: JP6714493B2
Patent Document 3: JP2020-183506A

### SUMMARY OF INVENTION

### TECHNICAL PROBLEM

The present invention has been made in view of the above-described circumstances. An object of the present invention is to provide: a method for forming, by performing plasma irradiation, a resist underlayer film that exhibits much better dry etching resistance than when a conventional organic underlayer film material is used, and exhibits excellent film thickness uniformity; and a patterning process in which the resist underlayer film is used.

### SOLUTION TO PROBLEM

To achieve the object, the present invention provides a method for forming a resist underlayer film on a substrate, the method comprising the steps of:
(i) forming an underlayer-film-precursor film by applying a composition for forming a resist underlayer film onto the substrate, the composition containing (A) a polymer and (B) an organic solvent, and subjecting the composition to heat treatment at a temperature of 100°C or higher and 800°C or lower for 10 seconds to 7,200 seconds to cure the composition; and
(ii) forming a resist underlayer film by subjecting the substrate having the underlayer-film-precursor film formed to plasma irradiation,

wherein the polymer (A) contains a constitutional unit represented by the following general formula (1) and has a weight-average molecular weight of 2,500 to 20,000 as measured by gel permeation chromatography in terms of polystyrene, 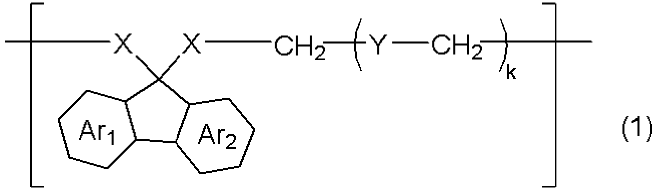
wherein Ar₁ and Ar₂ each independently represent a substituted or unsubstituted benzene ring or a substituted or unsubstituted naphthalene ring, X represents a structure represented by the following general formula (1A), Y represents a divalent organic group having 6 to 50 carbon atoms, and "k" represents 0 or 1, 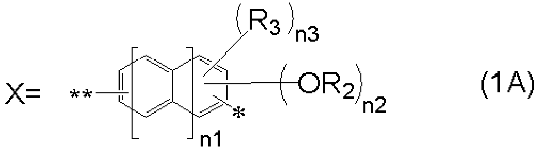
wherein "n₁" represents 0 or 1, "n₂" represents 1 or 2, R₂ represents a hydrogen atom or an organic group having 1 to 10 carbon atoms or has a structure represented by one of the following general formulae (1B), R₃ represents a hydrogen atom, a linear, branched, or cyclic alkyl group having 1 to 10 carbon atoms, an aryl group having 6 to 10 carbon atoms, or a group represented by the following general formula (1C), "n₃" represents 0, 1, or 2, "*" represents an attachment point to the methylene group, and "**" represents an attachment point to the quaternary carbon atom of the fluorene, 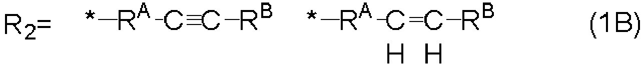
wherein "*" represents an attachment point to the oxygen atom, R^{A} represents a divalent organic group having 1 to 10 carbon atoms, and R^{B} represents a hydrogen atom or a monovalent organic group having 1 to 10 carbon atoms, 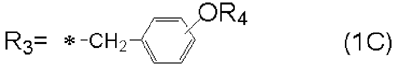
wherein R₄ represents a hydrogen atom or a saturated or unsaturated hydrocarbon group having 1 to 10 carbon atoms, a hydrogen atom on the benzene ring in the formula optionally being substituted with a methyl group or a methoxy group.

According to such a method for forming a resist underlayer film, modification of the film by irradiation with plasma occurs easily since a structure including a high-carbon-density fluorene skeleton is repeatedly bonded via a methylene group, and it is possible to provide a resist underlayer film excellent in dry etching resistance. Furthermore, by the crosslinking group structure containing the oxygen atom and the methylene group being contained, the curability, denseness, and heat resistance of the resist underlayer film are enhanced, so that the dispersal of solid components in the film due to plasma irradiation can be alleviated, and therefore, it is possible to form a resist underlayer film that undergoes little film-thickness change between before and after plasma irradiation and has both high film thickness uniformity and high dry etching resistance.

Furthermore, the Y in the general formula (1) preferably has a structure represented by any of the following formulae (Y-1), 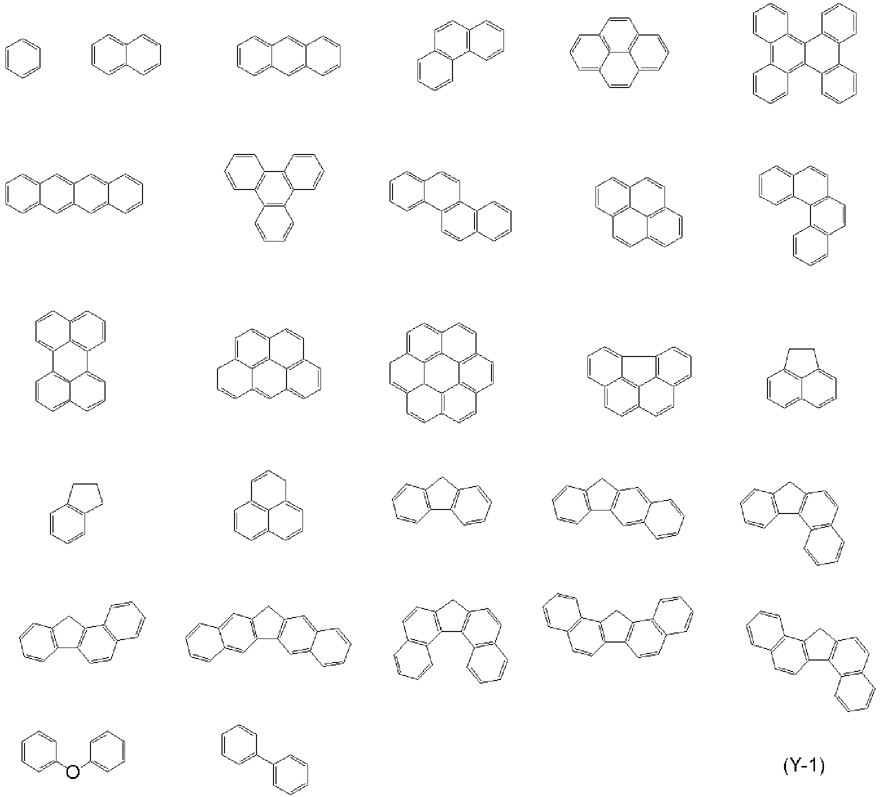 wherein a hydrogen atom of the structures is optionally substituted with a hydroxy group or a monovalent organic group having 1 to 10 carbon atoms.

According to such a method for forming a resist underlayer film, the modification of the film by the plasma irradiation is facilitated, and a resist underlayer film excellent in dry etching resistance can be provided.

Furthermore, the R₂ in the general formula (1A) is preferably a hydrogen atom.

According to such a method for forming a resist underlayer film, it is possible to provide a resist underlayer film excellent in adhesiveness to a substrate after the plasma irradiation. Moreover, the method also contributes to achieving higher density of the film, and is therefore preferable.

Furthermore, it is preferable that the R₂ in the general formula (1A) is a hydrogen atom or has the structure represented by the general formula (1B), and in the structure constituting the R₂, a proportion "a" of hydrogen atoms and a proportion "b" of the structure represented by the general formula (1B) satisfy relationships a + b = 1 and 0.1 ≤ b ≤ 0.9.

According to such a method for forming a resist underlayer film, it is possible to provide a resist underlayer film excellent in adhesiveness to a substrate after the plasma irradiation. In addition, a polymer excellent in flowability is formed, and therefore, it is possible to provide a method for forming a resist underlayer film excellent in planarizing property.

Furthermore, it is preferable that the Ar₁ and Ar₂ in the general formula (1) are each an unsubstituted benzene ring, and in the general formula (1A), "n1" is 0, "n2" is 1 or 2, and "n3" is 0.

According to such a method for forming a resist underlayer film, the modification of the film by the plasma irradiation is facilitated, and a resist underlayer film excellent in dry etching resistance can be provided. In addition, a polymer excellent in flowability is formed, and therefore, it is possible to provide a method for forming a resist underlayer film excellent in planarizing property.

The "k" in the general formula (1) is preferably 0.

According to such a method for forming a resist underlayer film, a polymer excellent in solvent solubility is formed, and therefore, the storage stability of the composition for forming a resist underlayer film is enhanced. Thus, a method for forming a resist underlayer film excellent in practicality can be provided.

The polymer (A) preferably has a weight-average molecular weight of 7000 to 15,000 as measured by gel permeation chromatography in terms of polystyrene.

According to such a method for forming a resist underlayer film, the curability, denseness, and heat resistance of the resist underlayer film are enhanced, and the dispersal of solid components in the film due to plasma irradiation can be alleviated. Therefore, it is possible to form a resist underlayer film having both high film thickness uniformity and high dry etching resistance.

Furthermore, the composition for forming a resist underlayer film preferably further contains one or more of: (C) a crosslinking agent; (D) a surfactant; (E) an acid generator; and (F) a plasticizer.

By using a composition for forming a resist underlayer film containing an additive mentioned above, it is possible to adjust, in appropriate ranges, various physical properties, such as coating property, film thickness uniformity, dry etching resistance, and filling and planarizing properties, required when the composition is used to form a resist underlayer film.

Furthermore, the organic solvent (B) is preferably a mixture of one or more kinds of organic solvent having a boiling point of lower than 180°C and one or more kinds of (B-1) a high-boiling-point solvent, being an organic solvent having a boiling point of 180°C or higher.

By using the composition for forming a resist underlayer film, containing such a component (B), it is possible to form a resist underlayer film excellent in planarizing property.

Furthermore, the plasma irradiation in the step (ii) is preferably performed under an atmosphere of N₂, NF₃, H₂, fluorocarbon, a rare gas, or a mixture of any thereof.

When the method for curing the resist underlayer film is plasma irradiation, it is possible to provide a resist underlayer film that exhibits better dry etching resistance than when the curing method is only heating.

Furthermore, the heat treatment in the step (i) is preferably performed under an atmosphere with an oxygen concentration of 1% or more and 21% or less.

According to such a method, it is possible to activate reactive sites of the resin in the resist underlayer film and promote the curing reaction performed by the plasma irradiation.

Furthermore, the heat treatment in the step (i) is preferably performed under an atmosphere with an oxygen concentration of less than 1%.

According to such a method, it is possible to activate reactive sites of the polymer in the resist underlayer film and promote the curing reaction performed by the plasma irradiation without causing degradation in the substrate to be processed even when the substrate to be processed contains a material that is unstable to heating under an oxygen atmosphere. Therefore, the method is useful.

The present invention also provides a patterning process for forming a pattern in a substrate to be processed, comprising the steps of:
(I-1) forming a resist underlayer film on a substrate to be processed by the above-described method for forming a resist underlayer film;
(I-2) forming a resist middle layer film on the resist underlayer film;
(I-3) forming a resist upper layer film on the resist middle layer film by using a photoresist material;
(I-4) subjecting the resist upper layer film to pattern exposure and then development with a developer to form a pattern in the resist upper layer film;
(I-5) transferring the pattern to the resist middle layer film by dry etching while using the resist upper layer film having the formed pattern as a mask;
(I-6) transferring the pattern to the resist underlayer film by dry etching while using the resist middle layer film having the transferred pattern as a mask; and
(I-7) processing the substrate to be processed while using the resist underlayer film having the formed pattern as a mask to form the pattern in the substrate to be processed.

According to the above-described patterning process, it is possible to form a fine pattern in a body to be processed with high precision.

The present invention also provides a patterning process for forming a pattern in a substrate to be processed, comprising the steps of:
(II-1) forming a resist underlayer film on a substrate to be processed having a step by the above-described method for forming a resist underlayer film;
(II-2) forming a resist upper layer film on the resist underlayer film;
(II-3) subjecting the resist upper layer film to pattern exposure and then development with a developer to form a pattern in the resist upper layer film;
(II-4) transferring the pattern to the resist underlayer film by dry etching while using the resist upper layer film having the formed pattern as a mask; and
(II-5) processing the substrate to be processed while using the resist underlayer film having the formed pattern as a mask to form the pattern in the substrate to be processed.

According to the above-described patterning process, it is possible to form a fine pattern in a body to be processed with high precision.

In this event, the step of the substrate to be processed preferably has an aspect ratio of 3 or higher.

The inventive patterning process makes it possible to form a resist underlayer film having high filling and planarizing properties, and therefore, is particularly useful for fine processing of a substrate having such a structure or step.

### ADVANTAGEOUS EFFECTS OF INVENTION

As described above, the inventive method for forming a resist underlayer film and patterning processes are suitably used particularly in a multilayer resist process, including filling and planarization of a substrate to be processed having steps and irregularities, and are significantly useful in fine patterning for the manufacture of semiconductor devices. In particular, in a fine patterning process using a multilayer resist method in a semiconductor device manufacturing process, even on a substrate to be processed having a portion where filling and planarization are difficult, such as a portion with a dense fine pattern structure portion with a high aspect ratio typified by a DRAM under progressing miniaturization, filling can be performed without causing defects such as voids and peeling. Therefore, a resist underlayer film having excellent planarizing property can be formed. Furthermore, the present inventions exhibit better etching resistance and film thickness uniformity than conventional methods for forming a resist underlayer film, and the effect can be exhibited particularly by performing plasma irradiation. Accordingly, it is possible to form a fine pattern in a body to be processed with even higher accuracy.

### BRIEF DESCRIPTION OF DRAWINGS

FIG. 1 is an explanatory view of an example (three-layer resist process) of the patterning process of the present invention.
FIG. 2 is an explanatory view of a method for evaluating filling property.
FIG. 3 is an explanatory view of a method for evaluating planarizing property.

### DESCRIPTION OF EMBODIMENTS

As stated above, there have been demands for the development of: a method for forming a resist underlayer film that makes it possible to transfer a resist pattern to a substrate to be processed with higher precision in a fine patterning process according to a multilayer resist method; and a patterning process using the resist underlayer film.

Patent Document 3 reports that the dry etching resistance of a resist underlayer film during substrate processing is enhanced by performing plasma irradiation. It is considered that carbon bonds of the resist underlayer film are dissociated and recombined by plasma irradiation to reconstruct a cured film having a diamond-like carbon structure, contributing to increase in hardness and density.

On the other hand, the compositions for forming a resist underlayer film used in the Examples of Patent Document 3 have insufficient curability of the resist underlayer films before the additional treatment, possibly because an oligomer having a molecular weight of 1,100 or less is used, and it is thought that not only the progress in the dissociation and recombination of the carbon bonds but also the dispersion of solid components in the film may be occurring actively. In the Examples, the change in film thickness caused by the plasma irradiation treatment is large and is 100 nm or more, and it is expected that the film thickness uniformity of the resist underlayer film after the plasma irradiation is also insufficient. When the resist underlayer films are used as filling films for stepped substrates to be processed, the possibility that flatness may be degraded by the effect of film shrinkage caused by plasma irradiation and electron beam irradiation and the possibility that voids may be generated in the filling film due to solid components in the film being excessively dispersed in the course of the plasma irradiation and the electron beam irradiation can be considered. For this reason, it is thought that a method for forming a resist underlayer film that undergoes little change in film thickness between before and after plasma irradiation is needed.

The present inventors have searched for a method for forming a resist underlayer film according to which it is possible to achieve both high dry etching resistance and high film thickness uniformity, and studied earnestly. As a result, the present inventors have found out that, according to a method for forming a resist underlayer film, including a step of forming an underlayer-film-precursor film by applying a composition for forming a resist underlayer film, containing (A) a polymer containing a constitutional unit represented by the general formula (1) and (B) an organic solvent, the polymer (A) having a weight-average molecular weight of 2,500 to 20,000 as measured by gel permeation chromatography in terms of polystyrene, and subjecting the composition to heat treatment at a temperature of 100°C or higher and 800°C or lower for 10 seconds to 7,200 seconds to cure the composition, and a step of forming a resist underlayer film (cured film) by subjecting the substrate having the underlayer-film-precursor film formed to plasma irradiation, it is possible to form a resist underlayer film that undergoes less change in film thickness between before and after the plasma irradiation and exhibits better dry etching resistance and better film thickness uniformity than conventional methods for forming a resist underlayer film, using plasma irradiation. Thus, the present invention has been completed.

Hereinafter, the present invention will be described in detail, but the present invention is not limited thereto.

### <Method for Forming Resist Underlayer Film>

The present invention is a method for forming a resist underlayer film on a substrate, the method including the steps of:
(i) forming an underlayer-film-precursor film by applying a composition for forming a resist underlayer film onto the substrate, the composition containing (A) a polymer and (B) an organic solvent, and subjecting the composition to heat treatment at a temperature of 100°C or higher and 800°C or lower for 10 seconds to 7,200 seconds to cure the composition; and
(ii) forming a resist underlayer film by subjecting the substrate having the underlayer-film-precursor film formed to plasma irradiation,
where the polymer (A) contains a constitutional unit represented by the following general formula (1) and has a weight-average molecular weight of 2,500 to 20,000 as measured by gel permeation chromatography in terms of polystyrene.

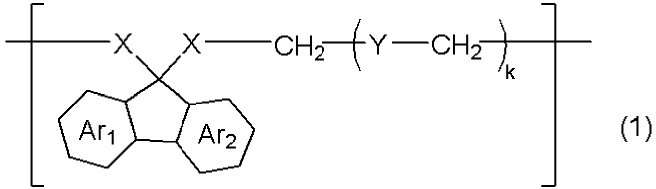

In the formula, Ar₁ and Ar₂ each independently represent a substituted or unsubstituted benzene ring or a substituted or unsubstituted naphthalene ring, X represents a structure represented by the following general formula (1A), Y represents a divalent organic group having 6 to 50 carbon atoms, and "k" represents 0 or 1.

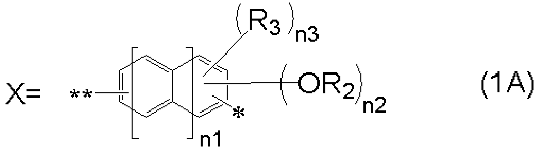

In the formula, "n₁" represents 0 or 1, "n₂" represents 1 or 2, R₂ represents a hydrogen atom or an organic group having 1 to 10 carbon atoms or has a structure represented by one of the following general formulae (1B), R₃ represents a hydrogen atom, a linear, branched, or cyclic alkyl group having 1 to 10 carbon atoms, an aryl group having 6 to 10 carbon atoms, or a group represented by the following general formula (1C), "n₃" represents 0, 1, or 2, "*" represents an attachment point to the methylene group, and "**" represents an attachment point to the quaternary carbon atom of the fluorene.

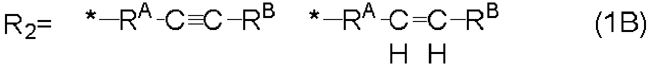

In the formulae, "*" represents an attachment point to the oxygen atom, R^{A} represents a divalent organic group having 1 to 10 carbon atoms, and R^{B} represents a hydrogen atom or a monovalent organic group having 1 to 10 carbon atoms.

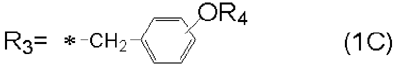

In the formula, R₄ represents a hydrogen atom or a saturated or unsaturated hydrocarbon group having 1 to 10 carbon atoms, a hydrogen atom on the benzene ring in the formula optionally being substituted with a methyl group or a methoxy group.

The method for applying the composition for forming a resist underlayer film in the step (i) is not particularly limited. Details of the composition for forming a resist underlayer film will be given later.

In the step (i), the temperature to heat-treat (bake) the coating film is 100°C or higher and 800°C or lower, preferably 150°C or higher and 600°C or lower, further preferably 150°C or higher and 400°C or lower, and further preferably 200°C or higher and 350°C or lower. The baking time is in a range of 10 seconds to 7,200 seconds, further preferably 30 seconds to 600 seconds.

By adjusting appropriately the baking temperature and time within the above-described ranges, it is possible to achieve curing properties, such as planarizing and filling properties, dry etching resistance, and heat resistance, suitable for the purpose. By performing the heat treatment (baking) within a temperature range of 150°C or higher and 400°C or lower, a state is achieved, where many active sites, at which dissociation and recombination of carbon bonds in the underlayer-film-precursor film occur, are contained in the film, and film modification by irradiation with plasma is more easily promoted, so that a resist underlayer film excellent in dry etching resistance can be formed. When the baking temperature is 100°C or higher, the solvent remaining in the film can be reduced, and degradation in film thickness uniformity due to plasma irradiation can be suppressed. When the baking temperature is 800°C or lower, thermal decomposition of the base resin can be suppressed, and it is possible to provide a resist underlayer film with little sublimation product. It is also possible to perform the heat treatment in multiple steps (step-baking) .

Furthermore, in the step (i), the heat treatment can be performed under an atmosphere having an oxygen concentration of 1% or more and 21% or less.

According to such a method, it is possible to activate reactive sites of the resin in the resist-underlayer-film-precursor film and promote the curing reaction performed by plasma irradiation.

Alternatively, in the step (i), the heat treatment can be performed under an atmosphere having an oxygen concentration of less than 1%.

As the atmosphere during the baking, it is possible to select, as necessary, an oxygen-containing atmosphere (oxygen concentration: 1% to 210), such as air, or a non-oxygen atmosphere, such as nitrogen. For example, in a case where the substrate to be processed easily undergoes air oxidation, damage to the substrate can be suppressed by performing the heat treatment in an atmosphere with an oxygen concentration of less than 1% to form a cured film.

For the plasma irradiation, a known method can be used. Examples include methods disclosed in JP5746670B2 and "Improvement of the wiggling profile of spin-on carbon hard mask by H₂ plasma treatment" (J. Vac. Sci. Technol. B26 (1), Jan/Feb 2008, p67-71).

RF discharge power is preferably 100 to 10,000 W, more suitably 500 to 5,000 W.

Examples of the gas atmosphere include N₂, NF₃, H₂, rare gases such as He, and fluorocarbon; and more suitable examples include He, Ar, N₂, Ne, NF₃, H₂, CF₄, CHF₃, CH₂F₂, CH₃F, C₄F₆, C₄F₈, etc. These gases may be used as a mixture of two or more kinds. An advantage of the present invention is that the advantageous effects of the present invention can be expected even when using a gas atmosphere not containing O₂.

The time of the plasma irradiation can be selected from, for example, 10 to 240 seconds. The pressure can be selected appropriately.

In the step (ii), the plasma irradiation is preferably performed under an atmosphere of N₂, NF₃, H₂, fluorocarbon, a rare gas such as He, or a mixture of any thereof.

From the viewpoint of productivity, examples of particularly favorable gas atmospheres include He, Ar, N₂, H₂, etc.

After the plasma irradiation, the resist underlayer film may be subjected to heat treatment. When heating is to be performed after the plasma irradiation, as the heating conditions, the heating temperature can be selected appropriately from the range of 80 to 800°C (preferably 100 to 700°C, more preferably 200 to 600°C), and the heating time from the range of 30 to 180 seconds (preferably 30 to 120 seconds). There are no restrictions by the theory, but it is considered that, by performing high-temperature heating after the plasma irradiation, dangling bonds are bonded, and this can contribute to higher density of the cured film (resist underlayer film).

As the atmosphere during the heating after the plasma irradiation, it is possible to select, as necessary, an oxygen-containing atmosphere (oxygen concentration: 1% to 210), such as air, or a non-oxygen atmosphere, such as nitrogen. For example, in a case where the substrate to be processed easily undergoes air oxidation, damage to the substrate can be suppressed by performing the heat treatment in an atmosphere with an oxygen concentration of less than 1% to form a cured film.

The irradiation apparatus is not particularly limited as long as plasma irradiation can be performed with the apparatus, and for example, it is possible to use Telius SP or Tactras Vigus manufactured by Tokyo Electron Ltd. It is possible to select an apparatus and set conditions in such a manner as to achieve the advantageous effects of the present invention more prominently.

In the inventive patterning processes, using the composition for forming a resist underlayer film described in detail below, it is preferable to use a substrate to be processed having a structure or step having an aspect ratio of 3 or higher or a height of 30 nm. The composition for forming a resist underlayer film used in the present invention is excellent in filling and planarizing properties, and therefore, a flat resist underlayer film (cured film) can be formed even when the substrate to be processed has a structure or step (irregularities) having an aspect ratio of 3 or higher or having a height of 30 nm or more. The structure that the substrate to be processed has preferably has an aspect ratio of 3 or higher, more preferably an aspect ratio of 5 or higher. The height of the structure or step that the substrate to be processed has is preferably 30 nm or more, more preferably 50 nm or more, and more preferably 100 nm or more. In a method for processing a stepped substrate having a pattern of the above-described aspect ratio and the above-described height, by forming a resist underlayer film according to the inventive method for forming a resist underlayer film to perform filling and planarization, it is possible to achieve a uniform film thickness in the subsequently formed resist middle layer film and resist upper layer film, and therefore, exposure depth margin (DOF) at the time of photolithography can be ensured easily, and this is extremely favorable.

### <Composition for Forming Resist Underlayer Film>

In the inventive method for forming a resist underlayer film, a composition for forming a resist underlayer film containing a polymer (A) and an organic solvent (B) is used, and the polymer (A) contains a constitutional unit of the following general formula (1) and has a weight-average molecular weight of 2,500 to 20,000 as measured by gel permeation chromatography in terms of polystyrene.

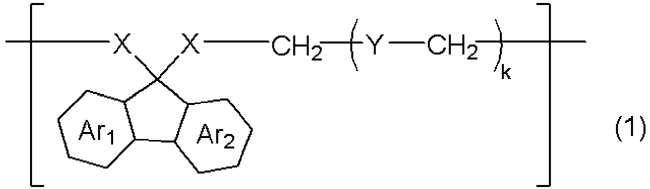

In the formula, Ar₁ and Ar₂ each independently represent a substituted or unsubstituted benzene ring or a substituted or unsubstituted naphthalene ring, X represents a structure represented by the following general formula (1A), Y represents a divalent organic group having 6 to 50 carbon atoms, and "k" represents 0 or 1.

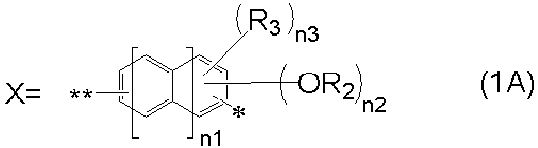

In the formula, "n₁" represents 0 or 1, "n₂" represents 1 or 2, R₂ represents a hydrogen atom or an organic group having 1 to 10 carbon atoms or has a structure represented by one of the following general formulae (1B), R₃ represents a hydrogen atom, a linear, branched, or cyclic alkyl group having 1 to 10 carbon atoms, an aryl group having 6 to 10 carbon atoms, or a group represented by the following general formula (1C), "n₃" represents 0, 1, or 2, "*" represents an attachment point to the methylene group, and "**" represents an attachment point to the quaternary carbon atom of the fluorene.

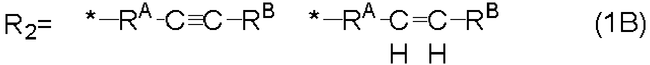

In the formulae, "*" represents an attachment point to the oxygen atom, R^{A} represents a divalent organic group having 1 to 10 carbon atoms, and R^{B} represents a hydrogen atom or a monovalent organic group having 1 to 10 carbon atoms.

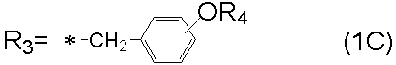

In the formula, R₄ represents a hydrogen atom or a saturated or unsaturated hydrocarbon group having 1 to 10 carbon atoms, a hydrogen atom on the benzene ring in the formula optionally being substituted with a methyl group or a methoxy group.

### [(A) Polymer (Resin)]

When the polymer (A) is a resin containing a constitutional unit represented by the general formula (1), a structure containing a fluorene skeleton, having a high carbon density, is bonded repeatedly via a methylene group, and therefore, the dissociation and recombination of carbon bonds are easily promoted by plasma irradiation, so that a resist underlayer film having a diamond-like carbon structure can be formed.

In addition, by the polymer containing a methylene group and a crosslinking group structure including an oxygen atom, the curability, denseness, and heat resistance of the resist underlayer film are improved, and the dispersion of solid components in the film due to plasma irradiation can be alleviated, and therefore, it is possible to form a resist underlayer film having both high film thickness uniformity and high dry etching resistance.

Examples of the divalent organic group having 1 to 10 carbon atoms represented by R^{A} in the general formulae (1B) include: alkanediyl groups, such as a methylene group, an ethanediyl group, a propanediyl group, a butanediyl group, a pentanediyl group, a hexanediyl group, an octanediyl group, and a decanediyl group; arenediyl groups, such as a benzenediyl group, a methylbenzenediyl group, and a naphthalenediyl group; etc.

Examples of the monovalent organic group having 1 to 10 carbon atoms represented by R^{B} in the general formulae (1B) include: alkyl groups, such as a methyl group, an ethyl group, an n-propyl group, an i-propyl group, an n-butyl group, an i-butyl group, a sec-butyl group, a t-butyl group, an n-pentyl group, an n-hexyl group, an n-octyl group, and an n-decyl group; aryl groups, such as a phenyl group, a tolyl group, a xylyl group, a mesityl group, and a naphthyl group; etc.

Part or all of the hydrogen atoms in the alkanediyl groups, arenediyl groups, alkyl groups, aryl groups, etc. may be substituted, and examples of substituents include: alkoxy groups, such as a methoxy group, an ethoxy group, an n-propoxy group, an i-propoxy group, an n-butoxy group, an i-butoxy group, a sec-butoxy group, a t-butoxy group, an n-pentyloxy group, and an n-hexyloxy group; alkoxycarbonyl groups, such as a methoxycarbonyl group, an ethoxycarbonyl group, a n-propoxycarbonyl group, an i-propoxycarbonyl group, an n-butoxycarbonyl group, an i-butoxycarbonyl group, a sec-butoxycarbonyl group, a t-butoxycarbonyl group, an n-pentyloxycarbonyl group, and an n-hexyloxycarbonyl group; etc.

Particularly favorable examples include the structures represented by the following formulae (1D). When such a structure is contained, excellent thermal flowability can be achieved, and it is possible to provide a resist underlayer film material excellent in filling and planarizing properties. In addition, excellent heat resistance and film-formability can be achieved, suppressing the generation of sublimation products at the time of heat-curing, suppressing the contamination of the apparatus due to sublimation products, making it possible to suppress the generation of coating defects.

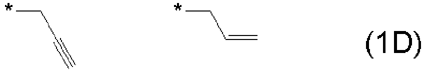

In the formulae, "*" represents an attachment point to the oxygen atom.

In the formula (1), Y preferably has one of the structures represented by the following formulae (Y-1). Note that, in the following structures, the positions of the attachment points to the methylene groups in the formula (1) are not particularly limited.

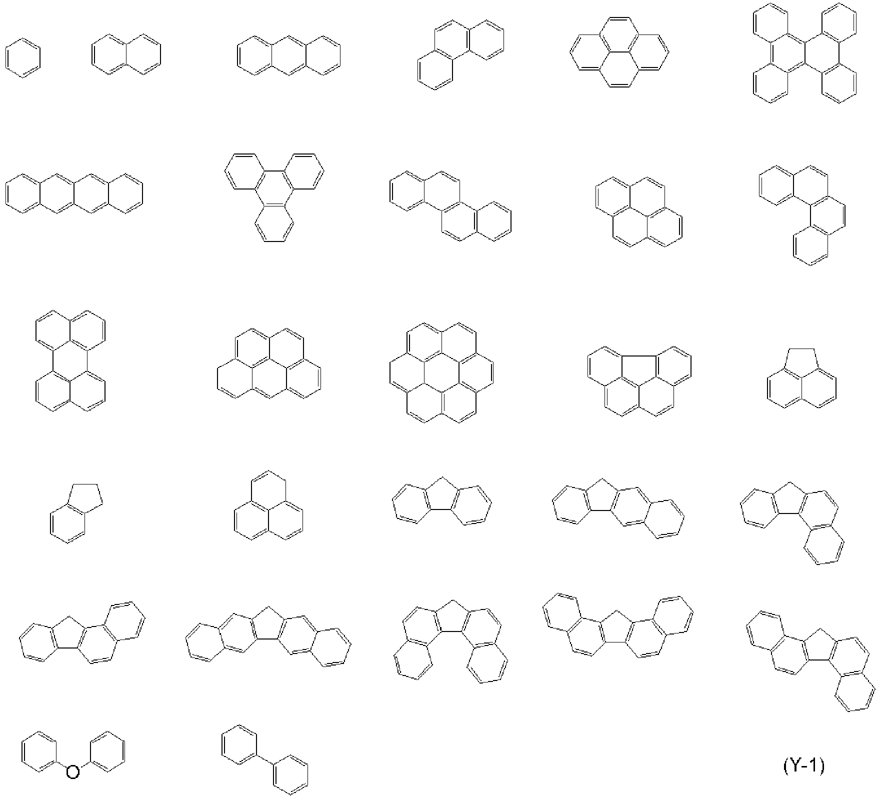

A hydrogen atom of the structures may be substituted with a hydroxy group or a monovalent organic group having 1 to 10 carbon atoms.

When a polymer containing a structure described above is used, the carbon density in the resist underlayer film is enhanced, and therefore, the dissociation and recombination of carbon bonds are easily promoted by plasma irradiation, so that it is possible to form a resist underlayer film having a diamond-like carbon structure.

A hydrogen atom of the above-described structures is optionally substituted with a hydroxy group or a monovalent organic group having 1 to 10 carbon atoms, and examples of the monovalent organic group having 1 to 10 carbon atoms include linear, branched, or cyclic alkyl groups having 1 to 10 carbon atoms, aryl groups having 6 to 10 carbon atoms, and groups represented by the following general formulae (Y-2).

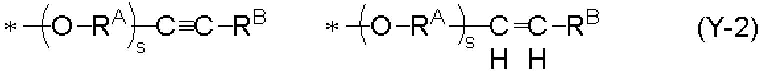

In the formulae, "*" represents an attachment point to the formula (Y-1) structure; R^{A} represents a divalent organic group having 1 to 10 carbon atoms; R^{B} represents a hydrogen atom or a monovalent organic group having 1 to 10 carbon atoms; and "s" represents 0 or 1.

From the viewpoint of dry etching resistance, the hydrogen atoms of the structures represented by the formulae (Y-1) are more preferably unsubstituted.

As more preferable examples of the structures represented by the formulae (Y-1), specifically, the following structures may be given.

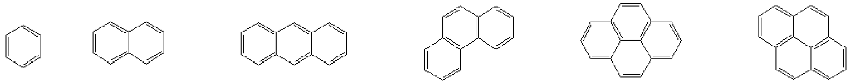

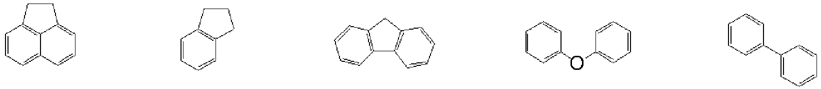

In the formula (1C), R₄ is preferably a hydrogen atom or a hydrocarbon group having 1 to 10 carbon atoms including an ethenyl group or an ethynyl group, and the hydrogen atoms on the benzene rings are preferably unsubstituted.

When the R₄ is a hydrogen atom, the curability of the polymer can be further enhanced, and the film thickness uniformity after the plasma irradiation can be further enhanced. When the R₄ is a hydrocarbon group having 1 to 10 carbon atoms including an ethenyl group or an ethynyl group, the flowability of the polymer can be further enhanced, and the planarizing property after the plasma irradiation can be further enhanced.

In the formula (1), it is preferable that Ar₁ and Ar₂ are each an unsubstituted benzene ring or an unsubstituted naphthalene ring, "n2" is 1, and "n3" is 0.

Furthermore, it is more preferable that in the formula (1), Ar₁ and Ar₂ are each an unsubstituted benzene ring, and that in the formula (1A), "n1" is 0, "n2" is 1 or 2, and "n3" is 0.

According to a method for forming a resist underlayer film where a composition for forming a resist underlayer film, containing such a polymer, is used, the dissociation and recombination of carbon bonds are easily promoted by plasma irradiation, and therefore, it is possible to form a resist underlayer film having a diamond-like carbon structure.

Furthermore, when a crosslinking group structure containing an oxygen atom is contained, the curability, denseness, and heat resistance of the resist underlayer film are improved, and it is possible to form a resist underlayer film excellent in film thickness uniformity before and after the plasma irradiation. On the other hand, a smaller amount of the crosslinking group structure containing an oxygen atom is preferable from the viewpoint of etching resistance, since the amount of oxygen atoms that remain in the film is reduced. Therefore, "n2" is more preferably 1 and "n3" is more preferably 0.

In the formula (1A), "k" is preferably 0.

According to such a method for forming a resist underlayer film, a polymer excellent in solvent solubility is formed, and therefore, the storage stability of the composition for forming a resist underlayer film is enhanced. Thus, a method for forming a resist underlayer film excellent in practicality can be provided.

Specific examples of preferable structures include the following structures (1-A1), but are not limited thereto.

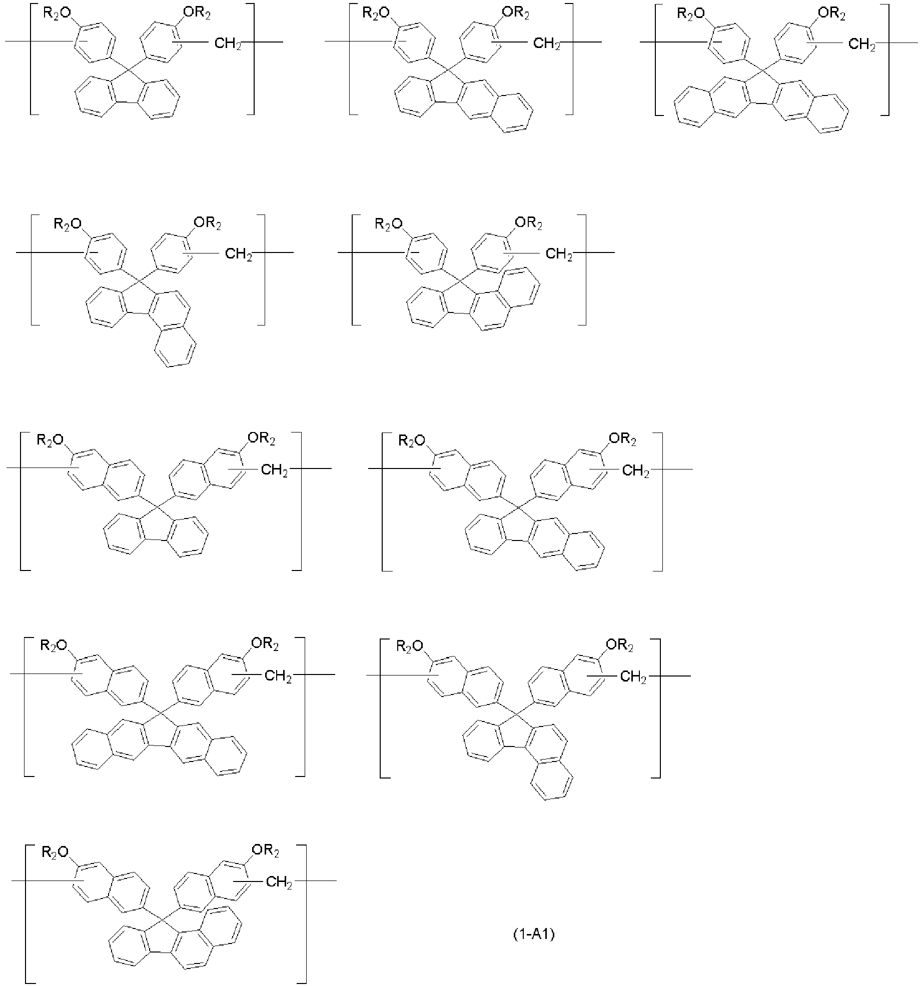

In the formulae, R₂ is as in the formula (1A).

In the formula (1A), "n1" is more preferably 0.

According to a method for forming a resist underlayer film in which a composition for forming a resist underlayer film containing such a polymer is used, a structure containing a fluorene skeleton, having a high carbon density, is bonded repeatedly via a methylene group, and therefore, the dissociation and recombination of carbon bonds are easily promoted by plasma irradiation, so that a resist underlayer film having a diamond-like carbon structure can be formed. In addition, a polymer excellent in flowability is formed, and therefore, it is possible to provide a method for forming a resist underlayer film excellent in planarizing property.

In the formula (1A), R₂ is more preferably a hydrogen atom or has a structure represented by the general formula (1B) from the viewpoint of curability.

When the crosslinking group structure is contained, the curability and heat resistance of the resist underlayer film are enhanced, and it is possible to form a resist underlayer film excellent in film thickness uniformity before and after the plasma irradiation.

It is preferable to use a polymer in which the R₂ in the formula (1A) is a hydrogen atom or has the structure represented by the general formula (1B), and in the structure constituting the R₂, a proportion "a" of hydrogen atoms and a proportion "b" of the structure represented by the general formula (1B) satisfy relationships a + b = 1 and 0.1 ≤ b ≤ 0.9.

By controlling the proportions of the hydrogen atoms and the general formula (1B) in the above-described range, high flowability and high substrate adhesiveness can be exhibited, and it is possible to provide a resist underlayer film material having enhanced filling and planarizing properties. When the range of "b" is b ≤ 0.9, the contained amount of hydroxy groups is sufficient, and excellent adhesiveness to a substrate can be achieved. In addition, to form a dense film, a crosslinking reaction between hydroxy groups is favorable, and it is also preferable from the viewpoint of heat resistance that hydroxy groups are contained at a certain proportion or higher. On the other hand, when the range of "b" is 0.1 ≤ b, the thermal flowability of the resin is sufficient, and excellent filling and planarizing properties can be achieved.

In the formula (1A), R₂ is further preferably a hydrogen atom.

According to a method for forming a resist underlayer film where a composition for forming a resist underlayer film, containing such a polymer, is used, the dissociation and recombination of carbon bonds are easily promoted by the plasma irradiation, and therefore, it is possible to form a resist underlayer film having a diamond-like carbon structure. Moreover, the curability, denseness, and heat resistance of the resist underlayer film are improved, so that the change in film thickness between before and after the plasma irradiation is small, and it is possible to form a resist underlayer film excellent in film thickness uniformity after the plasma irradiation.

The polymer (A) has a weight-average molecular weight of 2,500 to 20,000, preferably 5,000 to 18,000, and further preferably 7,000 to 15,000 as measured by gel permeation chromatography in terms of polystyrene. When the weight-average molecular weight is 2,500 or more, the amount of sublimation products can be suppressed, and thus, the degradation of film thickness uniformity can be suppressed. When the weight-average molecular weight is 20,000 or less, it is possible to maintain the solvent solubility of the resin and prevent precipitation over time, and therefore, this is preferable from the viewpoint of storage stability. Furthermore, flowability is excellent, and therefore, excellent filling property and excellent flatness can be realized. Moreover, it is possible to suppress outgas at the time of baking without degrading the solubility of the polymer in an organic solvent.

The dispersity (Mw/Mn) of the polymer (A) is preferably within the range of 1.2 to 12, and narrowing the molecular weight distribution by reducing monomer components, oligomer components, or low-molecular-weight compounds having a molecular weight (Mw) of 1,100 or less allows a higher crosslinking efficiency, and volatilized components during baking and during plasma irradiation can be suppressed, and thus, it is possible to form a resist underlayer film excellent in film thickness uniformity. By suppressing volatilized components during baking, it is also possible to prevent contamination around the baking cup. Note that Mn represents the number-average molecular weight.

The polymer (A) contains the constitutional unit of the formula (1), and it is also possible to allow copolymerization with another copolymerizable monomer (A-2). Specific examples include phenol, o-cresol, m-cresol, p-cresol, 2,3-dimethylphenol, 2,5-dimethylphenol, 3,4-dimethylphenol, 3,5-dimethylphenol, 2,4-dimethylphenol, 2,6-dimethylphenol, 2,3,5-trimethylphenol, 3,4,5-trimethylphenol, 2-t-butylphenol, 3-t-butylphenol, 4-t-butylphenol, 2-phenylphenol, 3-phenylphenol, 4-phenylphenol, 3,5-diphenylphenol, 2-naphthylphenol, 3-naphthylphenol, 4-naphthylphenol, 4-tritylphenol, resorcinol, 2-methylresorcinol, 4-methylresorcinol, 5-methylresorcinol, catechol, 4-t-butylcatechol, 2-methoxyphenol, 3-methoxyphenol, 2-propylphenol, 3-propylphenol, 4-propylphenol, 2-isopropylphenol, 3-isopropylphenol, 4-isopropylphenol, 2-methoxy-5-methylphenol, 2-t-butyl-5-methylphenol, pyrogallol, thymol, isothymol, 1-naphthol, 2-naphthol, 2-methyl-1-naphthol, 4-methoxy-1-naphthol, and 7-methoxy-2-naphthol, dihydroxynaphthalenes, such as 1,5-dihydroxynaphthalene, 1,7-dihydroxynaphthalene, and 2,6-dihydroxynaphthalene, methyl 3-hydroxynaphthalene-2-carboxylate, indene, hydroxyindene, benzofuran, hydroxyanthracene, acenaphthylene, biphenyl, bisphenol, trisphenol, dicyclopentadiene, tetrahydroindene, 4-vinylcyclohexene, norbornadiene, 5-vinylnorborna-2-ene, α-pinene, β-pinene, limonene, etc., and copolymers of three or more components including these monomers are also possible.

In a case where the polymer (A) contains a constitutional unit derived from the other monomer (A-2), the proportions of the constitutional unit of the formula (1) and the constitutional unit derived from the other monomer (A-2) preferably satisfy the relationships c + d = 1, 0.5 ≤ c ≤ 0.9, and 0.1 ≤ d ≤ 0.5, where the constitutional unit of the formula (1) is "c" and the constitutional unit derived from the other monomer (A-2) is "d".

When the constitutional unit derived from the other monomer (A-2) is contained, it is possible to adjust appropriately the coating property, film thickness uniformity, filling property, planarizing property, and dry etching resistance of the resist underlayer film, but to form a resist underlayer film excellent in dry etching resistance after the plasma irradiation, a polymer containing a large amount of the constitutional unit of the formula (1) is preferable, and a polymer not containing constitutional units derived from other monomers (A-2) is more preferable.

Note that the proportion of the polymer (A) contained in the composition for forming a resist underlayer film is not particularly limited, but for example, may be 1 to 50 parts by mass, preferably 1 to 20 parts by mass, and more preferably 1 to 10 parts by mass based on 100 parts by mass of the entire composition.

The polymer (A) contains a resin having the constitutional unit of the formula (1), and other compounds or polymers may further be blended. The blend compound or blend polymer is mixed with the resin having the structural unit represented by the general formula (1), and serves to improve film-formability by spin-coating or the property of filling a stepped substrate. Furthermore, as the blend compound or blend polymer, a compound having a phenolic hydroxy group is preferable.

Examples of such a material include novolak resins of phenol, o-cresol, m-cresol, p-cresol, 2,3-dimethylphenol, 2,5-dimethylphenol, 3,4-dimethylphenol, 3,5-dimethylphenol, 2,4-dimethylphenol, 2,6-dimethylphenol, 2,3,5-trimethylphenol, 3,4,5-trimethylphenol, 2-tert-butylphenol, 3-tert-butylphenol, 4-tert-butylphenol, 2-phenylphenol, 3-phenylphenol, 4-phenylphenol, 3,5-diphenylphenol, 2-naphthylphenol, 3-naphthylphenol, 4-naphthylphenol, 4-tritylphenol, resorcinol, 2-methylresorcinol, 4-methylresorcinol, 5-methylresorcinol, catechol, 4-tert-butylcatechol, 2-methoxyphenol, 3-methoxyphenol, 2-propylphenol, 3-propylphenol, 4-propylphenol, 2-isopropylphenol, 3-isopropylphenol, 4-isopropylphenol, 2-methoxy-5-methylphenol, 2-tert-butyl-5-methylphenol, pyrogallol, thymol, isothymol, 4,4'-(9H-fluorene-9-ylidene)bisphenol, 2,2'dimethyl-4,4'-(9H-fluorene-9-ylidene)bisphenol, 2,2'diallyl-4,4'-(9H-fluorene-9-ylidene)bisphenol, 2,2'difluoro-4,4'-(9H-fluorene-9-ylidene)bisphenol, 2,2'diphenyl-4,4'-(9H-fluorene-9-ylidene)bisphenol, 2,2'dimethoxy-4,4'-(9H-fluorene-9-ylidene)bisphenol, 2,3,2',3'-tetrahydro-(1,1')-spirobiindene-6,6'-diol, 3,3,3',3'-tetramethyl-2,3,2',3'-tetrahydro-(1,1')-spirobiindene-6,6'-diol, 3,3,3',3',4,4'-hexamethyl-2,3,2',3'-tetrahydro-(1,1')-spirobiindene-6,6'-diol, 2,3,2',3'-tetrahydro-(1,1')-spirobiindene-5,5'-diol, 5,5'-dimethyl-3,3,3',3'-tetramethyl-2,3,2',3'-tetrahydro-(1,1')-spirobiindene-6,6'-diol, 1-naphthol, 2-naphthol, 2-methyl-1-naphthol, 4-methoxy-1-naphthol, and 7-methoxy-2-naphthol, dihydroxynaphthalenes, such as 1,5-dihydroxynaphthalene, 1,7-dihydroxynaphthalene, and 2,6-dihydroxynaphthalene, methyl 3-hydroxynaphthalene-2-carboxylate, indene, hydroxyindene, benzofuran, hydroxyanthracene, acenaphthylene, biphenyl, bisphenol, trisphenol, dicyclopentadiene, tetrahydroindene, 4-vinylcyclohexene, norbornadiene, 5-vinylnorborna-2-ene, α-pinene, β-pinene, limonene, etc.; and polyhydroxystyrene, polystyrene, polyvinylnaphthalene, polyvinylanthracene, polyvinylcarbazole, polyindene, polyacenaphthylene, polynorbornene, polycyclodecene, polytetracyclododecene, polynortricyclene, poly(meth)acrylate, and copolymers thereof. It is also possible to blend a naphthol dicyclopentadiene copolymer disclosed in JP2004-205685A, a fluorene bisphenol novolak resin disclosed in JP2005-128509A, an acenaphthylene copolymer disclosed in JP2005-250434A, fullerene having a phenol group disclosed in JP2006-227391A, a bisphenol compound and a novolak resin thereof disclosed in JP2006-293298A, a novolak resin of an adamantane phenol compound disclosed in JP2006-285095A, a bisnaphthol compound and a novolak resin thereof disclosed in JP2010-122656A, a fullerene resin compound disclosed in JP2008-158002A, or the like.

The blend compound or blend polymer is preferably contained in an amount of 5 to 100 parts by mass, more preferably 5 to 50 parts by mass based on 100 parts by mass of the polymer (A) (the resin having the structural unit represented by the general formula (1)).

To form a resist underlayer film excellent in dry etching resistance after the plasma irradiation, the contained amount of the blend compound or blend polymer is preferably small, and the blend compound or blend polymer is more preferably not contained.

### [(B) Organic Solvent]

The organic solvent that can be used in the above-described composition for forming a resist underlayer film is not particularly limited as long as it is capable of dissolving the polymer (A), and an organic solvent also capable of dissolving a crosslinking agent, a surfactant, an acid generator, a plasticizer, which will be described later, is preferable.

Specifically, for example, a solvent disclosed in paragraphs [0091] and [0092] in JP2007-199653A may be contained. Further specifically, it is preferable to use propylene glycol monomethyl ether acetate, propylene glycol monomethyl ether, propylene glycol monoethyl ether, propylene glycol monopropyl ether, 2-heptanone, cyclopentanone, cyclohexanone, γ-butyrolactone, or a mixture containing one or more of these solvents.

It is desirable to adjust the amount of the organic solvent to be contained in accordance with the set film thickness of the resist underlayer film, and usually, the amount is 100 to 50,000 parts by mass based on 100 parts by mass of the polymer (A).

### [(B-1) High-Boiling-Point Solvent]

In the above-described composition for forming a resist underlayer film, the organic solvent (B) may be a mixture of one or more kinds of organic solvent having a boiling point of lower than 180°C and one or more kinds of organic solvent having a boiling point of 180°C or higher (hereinafter, referred to as "high-boiling-point solvent (B-1)").

Specific examples of organic solvents having a boiling point of lower than 180°C include propylene glycol monomethyl ether acetate, propylene glycol monomethyl ether, propylene glycol monoethyl ether, propylene glycol monopropyl ether, 2-heptanone, cyclopentanone, and cyclohexanone.

The high-boiling-point solvent (B-1) is not particularly limited to hydrocarbons, alcohols, ketones, esters, ethers, or chlorine-based solvents as long as the solvent is capable of dissolving the components of the composition for forming a resist underlayer film used in the present invention. Specific examples include 1-octanol, 2-ethylhexanol, 1-nonanol, 1-decanol, 1-undecanol, ethylene glycol, 1,2-propylene glycol, 1,3-butylene glycol, 2,4-pentanediol, 2-methyl-2,4-pentanediol, 2,5-hexanediol, 2,4-heptanediol, 2-ethyl-1,3-hexanediol, diethylene glycol, dipropylene glycol, triethylene glycol, tripropylene glycol, glycerin, n-nonyl acetate, monohexyl ether, ethylene glycol mono-2-ethylhexyl ether, ethylene glycol monophenyl ether, ethylene glycol monobenzyl ether, diethylene glycol monoethyl ether, diethylene glycol monoisopropyl ether, diethylene glycol mono-n-butyl ether, diethylene glycol monoisobutyl ether, diethylene glycol monohexyl ether, diethylene glycol monophenyl ether, diethylene glycol monobenzyl ether, diethylene glycol diethyl ether, diethylene glycol dibutyl ether, diethylene glycol butyl methyl ether, triethylene glycol dimethyl ether, triethylene glycol monomethyl ether, triethylene glycol-n-butyl ether, triethylene glycol butyl methyl ether, tetraethylene glycol dimethyl ether, dipropylene glycol monomethyl ether, dipropylene glycol mono-n-propyl ether, dipropylene glycol mono-n-butyl ether, tripropylene glycol dimethyl ether, tripropylene glycol monomethyl ether, tripropylene glycol mono-n-propyl ether, tripropylene glycol mono-n-butyl ether, ethylene glycol monoethyl ether acetate, ethylene glycol monobutyl ether acetate, diethylene glycol monomethyl ether acetate, diethylene glycol monoethyl ether acetate, diethylene glycol monobutyl ether acetate, triacetin, propylene glycol diacetate, dipropylene glycol methyl-n-propyl ether, dipropylene glycol methyl ether acetate, 1,4-butanediol diacetate, 1,3-butylene glycol diacetate, 1,6-hexanediol diacetate, triethylene glycol diacetate, γ-butyrolactone, methyl benzoate, ethyl benzoate, propyl benzoate, butyl benzoate, dihexyl malonate, diethyl succinate, dipropyl succinate, dibutyl succinate, dihexyl succinate, dimethyl adipate, diethyl adipate, dibutyl adipate, and the like. One of the solvents may be used or a mixture of two or more kinds may be used.

The high-boiling-point solvent (B-1) may be selected suitably from the solvents above, for example, depending on the temperature at which the above-described composition for forming a resist underlayer film is heat-treated, etc. The boiling point of the high-boiling-point solvent (B-1) is preferably 180°C to 300°C, further preferably 200°C to 300°C. When the boiling point is as described, sufficient thermal flowability can be achieved at the time of film formation, since there is no risk of excessive evaporation rate at the baking (heating) due to the boiling point being too low. Moreover, a solvent having such a boiling point does not remain in the film without evaporating even after the baking due to the boiling point being too high. Therefore, there is no risk of the solvent adversely affecting the physical properties, such as etching resistance, of the film.

Furthermore, when the high-boiling-point solvent (B-1) is used, the amount to be blended is preferably 1 to 200 parts by mass, more preferably 1 to 100 parts by mass per 100 parts by mass of the polymer (A). When the contained amount is as described, there are no risks that sufficient thermal flowability cannot be imparted at the time of baking due to the contained amount being too small or that the solvent remains in the film due to the contained amount being too large and leads to degradation of physical properties, such as etching resistance, of the film. Therefore, such an amount is preferable.

### [(C) Crosslinking Agent]

To increase curability and enhance dry etching resistance, a crosslinking agent (C) can also be added to the above-described composition for forming a resist underlayer film.

Specifically, as the crosslinking agent (C), a compound having a structure represented by the following general formula (C-1) is particularly preferable.

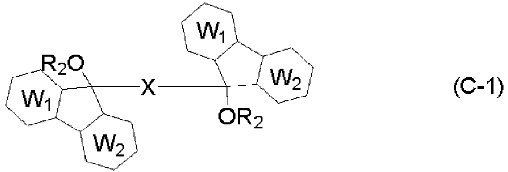

In the general formula (C-1), W₁ and W₂ each represent a benzene ring or naphthalene ring optionally having a substituent; R₂ represents a hydrogen atom or a monovalent organic group having 1 to 20 carbon atoms; and X represents any group represented by the following general formulae (2).

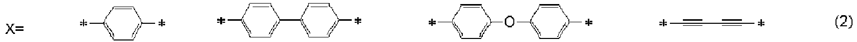

In the formulae, "*" represents an attachment point.

When the crosslinking agent (C) is contained, the crosslinking density and hardness of the resist underlayer film can be enhanced further without degrading the dry etching resistance of the composition for forming a resist underlayer film.

The crosslinking agent (C) preferably satisfies 1.00 ≤ Mw/Mn ≤ 1.25, where Mw is a weight-average molecular weight and Mn is a number-average molecular weight measured by gel permeation chromatography in terms of polystyrene.

When the molecular weight dispersity of the crosslinking agent are as described above, the thermal flowability of the composition for forming a resist underlayer film is excellent, and therefore, when the crosslinking agent is added to a resist underlayer film material, it is possible to form a resist underlayer film that can not only fill well a fine structure formed on a substrate but also achieve flatness across the entire substrate.

In addition, the crosslinking agent (C) is not particularly limited, and various known crosslinking agents can be widely used. Examples thereof include melamine-based crosslinking agents, glycoluril-based crosslinking agents, benzoguanamine-based crosslinking agents, urea-based crosslinking agents, β-hydroxyalkylamide-based crosslinking agents, isocyanurate-based crosslinking agents, aziridine-based crosslinking agents, oxazoline-based crosslinking agents, epoxy-based crosslinking agents, and phenol-based crosslinking agents (e.g. methylol or alkoxymethyl-based crosslinking agents of polynuclear phenols).

Specific examples of the melamine-based crosslinking agents include hexamethoxymethylated melamine, hexabutoxymethylated melamine, alkoxy- and/or hydroxy-substituted derivatives thereof, and partial self-condensates thereof. Specific examples of the glycoluril-based crosslinking agents include tetramethoxymethylated glycoluril, tetrabutoxymethylated glycoluril, alkoxy- and/or hydroxy-substituted derivatives thereof, and partial self-condensates thereof. Specific examples of the benzoguanamine-based crosslinking agents include tetramethoxymethylated benzoguanamine, tetrabutoxymethylated benzoguanamine, alkoxy- and/or hydroxy-substituted derivatives thereof, and partial self-condensates thereof. Specific examples of the urea-based crosslinking agents include dimethoxymethylated dimethoxyethyleneurea, alkoxy- and/or hydroxy-substituted derivatives thereof, and partial self-condensates thereof. Specific examples of the β-hydroxyalkylamide-based crosslinking agents include N,N,N',N'-tetra(2-hydroxyethyl)adipic acid amide. Specific examples of the isocyanurate-based crosslinking agents include triglycidyl isocyanurate and triallyl isocyanurate. Specific examples of the aziridine-based crosslinking agents include 4,4'-bis(ethyleneiminocarbonylamino)diphenylmethane and 2,2-bishydroxymethylbutanol-tris[3-(1-aziridinyl)propionate]. Specific examples of the oxazoline-based crosslinking agents include 2,2'-isopropylidene bis(4-benzyl-2-oxazoline), 2,2'-isopropylidene bis(4-phenyl-2-oxazoline), 2,2'-methylene bis-4,5-diphenyl-2-oxazoline, 2,2'-methylene bis-4-phenyl-2-oxazoline, 2,2'-methylene bis-4-tert-butyl-2-oxazoline, 2,2'-bis(2-oxazoline), 1,3-phenylene bis(2-oxazoline), 1,4-phenylene bis(2-oxazoline), and a 2-isopropenyloxazoline copolymer. Specific examples of the epoxy-based crosslinking agents include diglycidyl ether, ethylene glycol diglycidyl ether, 1,4-butanediol diglycidyl ether, 1,4-cyclohexane dimethanol diglycidyl ether, poly(glycidyl methacrylate), trimethylolethane triglycidyl ether, trimethylolpropane triglycidyl ether, and pentaerythritol tetraglycidyl ether.

Specific examples of the polynuclear phenol-based crosslinking agents include compounds represented by the following general formula (C-2).

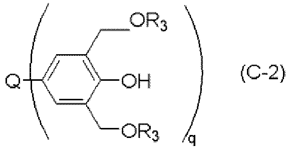

In the formula, Q represents a single bond or a q-valent hydrocarbon group having 1 to 20 carbon atoms. R₃ represents a hydrogen atom or a methyl group. "q" represents an integer of 1 to 5.

The Q in the general formula (C-2) represents a single bond or a hydrocarbon group having a valency of "q" and having 1 to 20 carbon atoms. "q" represents an integer of 1 to 5, more preferably 2 or 3. When Q is a q-valent hydrocarbon group having 1 to 20 carbon atoms, Q is obtained by removing "q" hydrogen atoms from a hydrocarbon having 1 to 20 carbon atoms. More specific examples of the hydrocarbon having 1 to 20 carbon atoms in this case include methane, ethane, propane, butane, isobutane, pentane, cyclopentane, hexane, cyclohexane, methylpentane, methylcyclohexane, dimethylcyclohexane, trimethylcyclohexane, benzene, toluene, xylene, ethylbenzene, ethylisopropylbenzene, diisopropylbenzene, methylnaphthalene, ethylnaphthalene, and eicosane.

The R₃ in the general formula (C-2) represents a hydrogen atom or a methyl group, preferably a methyl group.

When the compound represented by the general formula (C-2) is contained as a crosslinking agent (C), the denseness of the film can be enhanced. This makes it possible to enhance further the heat resistance of the composition for forming a resist underlayer film.

Specific examples of the compound represented by the general formula (C-2) include the following compounds, but are not limited thereto. In the following formulae, R₃ is as defined above. Examples where "q" is 3 and R₃ is a methyl group are preferable from the viewpoints of enhancing curability and film thickness uniformity and reducing sublimation products, and hexamethoxymethylated derivatives of triphenolmethane, triphenolethane, 1,1,1-tris(4-hydroxyphenyl)ethane, and tris(4-hydroxyphenyl)-1-ethyl-4-isopropylbenzene are particularly preferable.

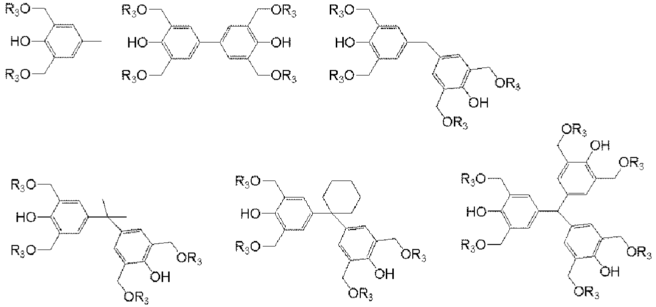

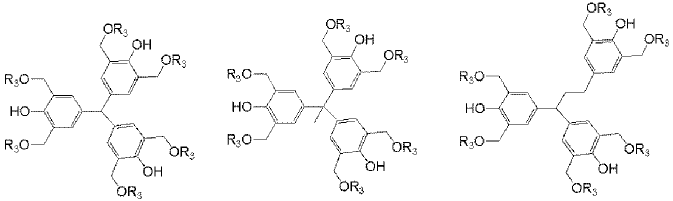

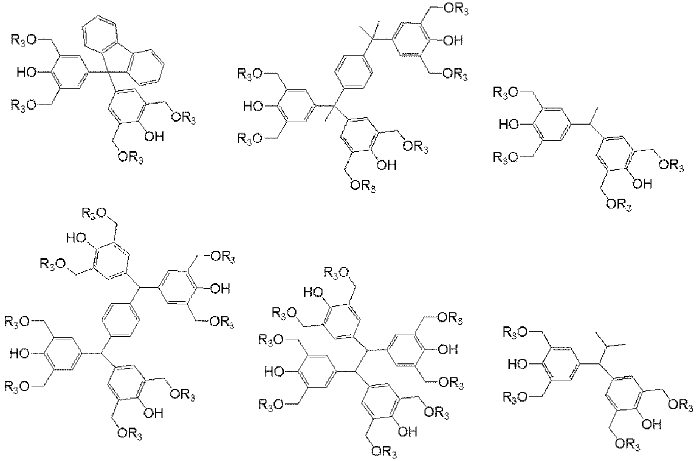

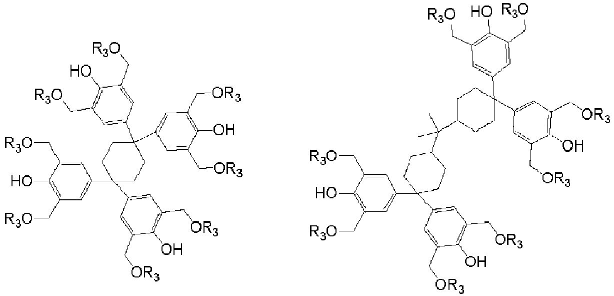

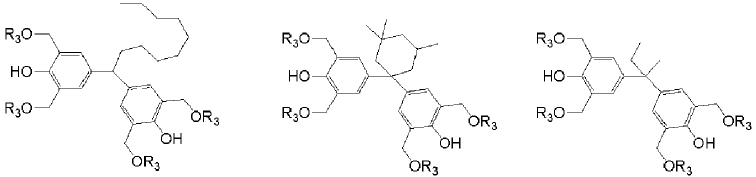

One kind of the crosslinking agent (C) can be used, or two or more kinds thereof can be used in combination. The amount of the crosslinking agent (C) to be contained is preferably 5 parts by mass to 100 parts by mass, more preferably 10 parts by mass to 50 parts by mass based on 100 parts by mass of the polymer (A). When the added amount is 5 parts by mass or more, a crosslinking reaction with the polymer (A) is promoted and a dense film excellent in curability is formed, and therefore, it is possible to form a resist underlayer film excellent in heat resistance, dry etching resistance, and film thickness uniformity. Meanwhile, when the added amount is 100 parts by mass or less, it is possible to suppress the generation of sublimation products that accompanies slowdown of a crosslinking reaction between the polymer (A) and the crosslinking agent (C), and it is possible to reduce the generation of sublimation products and the degradation of film thickness uniformity.

### [(D) Surfactant]

A surfactant (D) may be contained in the above-described composition for forming a resist underlayer film in order to improve coating property in spin-coating. Examples of the surfactant include those disclosed in paragraphs [0142] to [0147] of JP2009-269953A. When the surfactant is contained, the contained amount is preferably 0.001 to 20 parts by mass, more preferably 0.01 to 10 parts by mass per 100 parts by mass of the polymer (A).

### [(E) Acid Generator]

An acid generator (E) that can be contained in the above-described composition for forming a resist underlayer film can be classified into those that generate an acid by thermal decomposition and those that generate an acid by optical irradiation; however, any acid generator can be added. Specific examples of the acid generator include the materials disclosed in paragraphs [0061] to [0085] of JP2007-199653A, but are not limited thereto.

One kind of the acid generator can be used, or two or more kinds can be used in combination. When the acid generator is contained, the contained amount is preferably 0.05 to 50 parts by mass, more preferably 0.1 to 10 parts by mass relative to 100 parts by mass of the polymer (A).

### [(F) Plasticizer]

A plasticizer (F) may be contained in the above-described composition for forming a resist underlayer film in order to improve further the thermal flowability. The plasticizer is not particularly limited, and various known plasticizers can be widely used. Examples of the plasticizer include low molecular weight compounds, such as phthalate esters, adipate esters, phosphate esters, trimellitate esters, and citrate esters; and polymers, such as polyether-based polymers, polyester-based polymers, and polyacetal-based polymers disclosed in JP2013-253227A. When the plasticizer is contained, the contained amount is preferably 5 to 500 parts by mass, more preferably 10 to 200 parts by mass per 100 parts by mass of the polymer (A) .

Besides the above-described additives, it is also possible to add an additive for further enhancing thermal flowability (flowability accelerator) to the above-described composition for forming a resist underlayer film. The additive is not particularly limited as long as it contributes to the enhancement of thermal flowability and imparts filling property and planarizing property. For example, it is preferable to use a liquid additive having a polyethylene glycol or polypropylene glycol structure, or a thermo-decomposable polymer having a weight reduction rate of 40% by mass or more on heating from 30°C to 250°C and a weight-average molecular weight of 300 to 200,000. This thermo-decomposable polymer preferably contains a repeating unit having an acetal structure represented by the following general formula (DP1) or (DP1a).

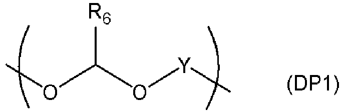

In the formula, R₆ represents a hydrogen atom or a saturated or unsaturated monovalent organic group having 1 to 30 carbon atoms, the organic group optionally being substituted. Y represents a saturated or unsaturated divalent organic group having 2 to 30 carbon atoms.

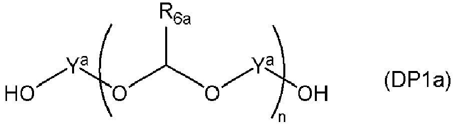

In the formula, R₆ₐ represents an alkyl group having 1 to 4 carbon atoms. Y^{a} represents a saturated or unsaturated divalent hydrocarbon group having 4 to 10 carbon atoms and optionally having an ether bond. "n" represents an average repeating unit number of 3 to 500.

### <Patterning Process>

The present invention also provides, as a patterning process according to a two-layer resist process using the above-described composition for forming a resist underlayer film, a patterning process including:
forming a resist underlayer film on a substrate to be processed by the inventive method for forming a resist underlayer film;
forming a resist upper layer film on the resist underlayer film by using a photoresist material;
subjecting the resist upper layer film to pattern exposure and then development with a developer to form a pattern in the resist upper layer film;
transferring the pattern to the resist underlayer film by dry etching while using the resist upper layer film having the formed pattern as a mask; and
processing the substrate to be processed while using the resist underlayer film having the formed pattern as a mask to form the pattern in the substrate to be processed.

The resist upper layer film in the two-layer resist process described above is preferably a photosensitive organic metal oxide film. The photosensitive organic metal oxide film exhibits etching resistance with respect to oxygen-based gas; therefore, the dry etching of the resist underlayer film that is performed while using the resist upper layer film as a mask in the two-layer resist process is preferably performed using an etching gas mainly containing an oxygen-based gas.

The present invention also provides, as a patterning process using a three-layer resist process using the above-described composition for forming a resist underlayer film, a patterning process for forming a pattern in a substrate to be processed, including the steps of:
(I-1) forming a resist underlayer film on a substrate to be processed by the inventive method for forming a resist underlayer film;
(I-2) forming a resist middle layer film on the resist underlayer film;
(I-3) forming a resist upper layer film on the resist middle layer film by using a photoresist material;
(I-4) subjecting the resist upper layer film to pattern exposure and then development with a developer to form a pattern in the resist upper layer film;
(I-5) transferring the pattern to the resist middle layer film by dry etching while using the resist upper layer film having the formed pattern as a mask;
(I-6) transferring the pattern to the resist underlayer film by dry etching while using the resist middle layer film having the transferred pattern as a mask; and
(I-7) processing the substrate to be processed while using the resist underlayer film having the formed pattern as a mask to form the pattern in the substrate to be processed.

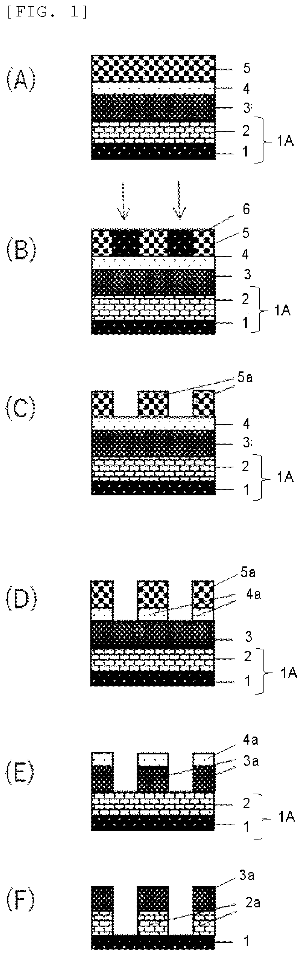

With reference to FIG. 1, an example of a patterning process according to a three-layer resist process will be described. Firstly, as shown in FIG. 1 (A), a resist underlayer film 3 is formed by the inventive method for forming a resist underlayer film on a layer 2 to be processed of a substrate 1A to be processed, including a support substrate 1 and the layer 2 to be processed formed thereon, a resist middle layer film 4 (e.g. a silicon-containing resist middle layer film) is formed on the resist underlayer film 3 by using a resist middle layer film material, and a resist upper layer film 5 is formed on the resist middle layer film 4 by using a photoresist material. Subsequently, as in FIG. 1 (B), an exposure portion 6 is formed in the resist upper layer film 5 by pattern exposure. Then, the exposure portion 6 is developed with a developer to form a resist upper layer film pattern 5a in the resist upper layer film 5 as in FIG. 1 (C). Subsequently, as in FIG. 1 (D), a resist middle layer film pattern 4a is transferred to the resist middle layer film 4 by dry etching while using the resist upper layer film 5 having the formed pattern 5a as a mask. Subsequently, as in FIG. 1 (E), a resist underlayer film pattern 3a is transferred to the resist underlayer film 3 by dry etching while using the resist middle layer film 4 having the transferred pattern 4a as a mask. Then, as in FIG. 1 (F), the layer 2 to be processed of the substrate 1A to be processed is processed while using the resist underlayer film 3 having the formed pattern 3a as a mask to form a pattern 2a on the substrate 1 to be processed.

The silicon-containing resist middle layer film in the three-layer resist process exhibits etching resistance with respect to an oxygen-based gas. Therefore, the dry etching of the resist underlayer film that is performed while using the silicon-containing resist middle layer film as a mask in the three-layer resist process is preferably performed using an etching gas mainly containing an oxygen-based gas.

As the silicon-containing resist middle layer film in the three-layer resist process, a polysiloxane-based middle layer film is also favorably used. This allows the silicon-containing resist middle layer film to possess an antireflective effect, thereby suppressing reflection. When a material containing many aromatic groups and having a high etching selectivity with respect to the substrate is used as the organic film especially for 193-nm exposure, the k-value increases and thus the substrate reflection increases; however, the reflection can be suppressed by imparting absorption so that the silicon-containing resist middle layer film has an appropriate k-value. In this manner, the substrate reflection can be reduced to 0.5% or less. Preferably used as the silicon-containing resist middle layer film having an antireflective effect is a polysiloxane, which has a pendant anthracene for exposure at 248 nm or 157 nm, or a pendant phenyl group or a pendant light-absorbing group having a silicon-silicon bond for 193 nm exposure, and which is crosslinked by an acid or heat.

In addition, the present invention provides a patterning process by way of a four-layer resist process using such a composition for forming a resist underlayer film, the patterning process including the steps of:
forming a resist underlayer film on a substrate to be processed by using the inventive method for forming a resist underlayer film;
forming a silicon-containing resist middle layer film on the resist underlayer film by using a silicon-containing resist middle layer film material;
forming an organic antireflective film (BARC) or an adhesive film on the silicon-containing resist middle layer film;
forming a resist upper layer film on the BARC or the adhesive film by using a photoresist material;
subjecting the resist upper layer film to pattern exposure and then development with a developer, thereby forming a pattern in the resist upper layer film;
transferring the pattern to the BARC or the adhesive film and the silicon-containing resist middle layer film by dry etching while using the resist upper layer film having the formed pattern as a mask;
transferring the pattern to the resist underlayer film by dry etching while using the silicon-containing resist middle layer film having the transferred pattern as a mask; and
processing the substrate to be processed while using the resist underlayer film having the formed pattern as a mask, thereby forming the pattern in the substrate to be processed.

Alternatively, an inorganic hard mask may be formed instead of the silicon-containing resist middle layer film. In this case, a semiconductor device circuit pattern can be formed on a substrate, at least, by:
forming a resist underlayer film on a body to be processed by using the composition of the present invention for forming a resist underlayer film;
forming an inorganic hard mask selected from a silicon oxide film, a silicon nitride film, and a silicon oxynitride film on the resist underlayer film;
forming a resist upper layer film on the inorganic hard mask by using a photoresist composition;
forming a circuit pattern in the resist upper layer film;
etching the inorganic hard mask while using the resist upper layer film having the formed pattern as a mask;
etching the resist underlayer film while using the inorganic hard mask having the formed pattern as a mask; and
furthermore, etching the body to be processed while using the resist underlayer film having the formed pattern as a mask to form the pattern in the body to be processed.

As described above, when the inorganic hard mask is formed on the resist underlayer film, a silicon oxide film, a silicon nitride film, and a silicon oxynitride film (SiON film) can be formed by a CVD method, an ALD method, etc. The method for forming the silicon nitride film is disclosed, for example, in JP2002-334869A and WO2004/066377A1. The film thickness of the inorganic hard mask is preferably 5 to 200 nm, more preferably 10 to 100 nm. The SiON film, which has a high function as an antireflective film, is the most favorably used as the inorganic hard mask. Since the substrate temperature increases to 300 to 500°C when the SiON film is formed, the resist underlayer film needs to withstand a temperature of 300 to 500°C. The composition for forming a resist underlayer film used in the present invention has high heat resistance and can withstand a high temperature of 300°C to 500°C. Thus, the resist underlayer film formed by spin-coating and the inorganic hard mask formed by the CVD method or the ALD method can be combined.

A photoresist film may be formed on the inorganic hard mask as the resist upper layer film as described above. Alternatively, an organic antireflective film (BARC) or an adhesive film may be formed on the inorganic hard mask by spin-coating, and a photoresist film may be formed thereon. In particular, when a SiON film is used as the inorganic hard mask, the reflection can be suppressed by the two antireflective films, i.e., the SiON film and the BARC film, even in liquid immersion exposure at a high NA exceeding 1.0. Another merit of forming BARC resides in that it has an effect to reduce a footing profile of a photoresist pattern immediately above the SiON film.

In the above-described patterning process, the resist upper layer film may be either a positive type or a negative type, and it is possible to use a film similar to the typically used photoresist composition. The photoresist composition may also contain a metal atom such as Sn, In, Ga, Ge, Al, Ce, La, Cs, Zr, Hf, Ti, Bi, Sb, and Zn. In a case where the resist upper layer film is formed with the photoresist composition, a spin-coating method may be employed, or the film may be formed by a deposition treatment according to CVD or ALD.

In a case where the photoresist composition is formed by a spin-coating method, prebaking is conducted after applying the resist. The prebaking is preferably performed at 60 to 180°C for 10 to 300 seconds. Thereafter, exposure is conducted according to a usual manner, followed by post-exposure baking (PEB) and development, thereby obtaining a resist pattern. Although the thickness of the resist upper layer film is not particularly limited, the thickness is preferably 10 to 500 nm, particularly preferably 20 to 400 nm.

In a case where the photoresist composition is to be formed by a deposition treatment according to CVD or ALD, the resist composition is a metal oxide film having photosensitivity to EUV, and the metal is selected from Sn, Zr, Hf, Ti, Bi, Sb, etc. In particular, Sn, which has excellent photosensitivity to EUV, is preferable. The metal-oxide-containing film may be a photosensitive organometallic oxide film such as an organotin oxide (for example, haloalkyl Sn, alkoxyalkyl Sn, or amidoalkyl Sn). Some specific examples of suitable precursors include trimethyltin chloride, dimethyltin dichloride, methyltin trichloride, tris(dimethylamino)methyl tin(IV), and (dimethylamino)trimethyl tin(IV).

The metal oxide film may be deposited by PECVD or PEALD, for example, by using a Lam Vector (registered trademark) tool, separating the Sn oxide precursor from O precursor/plasma in the ALD implementation. Deposition temperature is preferably 50°C to 600°C. Deposition pressure is preferably between 100 and 6,000 mTorr. Precursor liquid flow rates for metal oxide-containing film (e.g., an organotin oxide precursor) can be 0.01 to 10 cmm, and gas flow rates (CO₂, CO, Ar, and N₂) can be 100 to 10,000 sccm. Plasma powers can be 200 to 1,000 W per 300 mm wafer station, using a highfrequency plasma (e.g., 13.56 MHz, 27.1 MHz, or higher). Deposited thickness is preferably 100 to 2,000 Å.

Examples of light for exposure include high-energy beams at wavelengths of 300 nm or less, specifically excimer lasers at 248 nm, 193 nm, and 157 nm, soft X-rays at 3 to 20 nm, an electron beam, X-rays, and the like.

As the method for forming a pattern in the resist upper layer film, it is preferable to use a patterning process using a photolithography with a wavelength of 5 nm or more and 300 nm or less, a direct drawing using an electron beam, nanoimprinting, or a combination thereof.

The development method in the patterning process is preferably alkali development or development using an organic solvent.

Next, etching is performed while using the obtained resist pattern as a mask. The etching of a silicon-containing resist middle layer film or an inorganic hard mask in the three-layer resist process is performed while using the upper layer resist pattern as a mask by using a fluorocarbon-based gas. In this manner, a silicon-containing resist middle layer film pattern or an inorganic hard mask pattern is formed.

Next, the resist underlayer film is etched while using the obtained silicon-containing resist middle layer film pattern or inorganic hard mask pattern as a mask. The etching of the resist underlayer film is preferably performed using an etching gas mainly containing an oxygen-based gas.

The subsequent etching of a body to be processed may also be performed according to a usual manner. For example, in the case of a body to be processed made of SiO₂, SiN or silica-based low dielectric constant insulating film, the etching is performed mainly based on a fluorocarbon-based gas. When the substrate is processed by way of etching with a fluorocarbon-based gas, the silicon-containing resist middle layer film pattern in the three-layer resist process is stripped simultaneously with the substrate processing.

The resist underlayer film obtained by the inventive method for forming a resist underlayer film is characterized by its excellent etching resistance at the time of etching of the body to be processed.

Examples of the body to be processed (substrate to be processed) include, but are not particularly limited to, substrates made of Si, α-Si, p-Si, SiO₂, SiN, SiON, W, TiN, Al, etc., those in which a layer to be processed is formed on the substrate (support substrate), and the like. Examples of the layer to be processed include various low-k films such as those made of Si, SiO₂, SiON, SiN, p-Si, α-Si, W, W-Si, Al, Cu, Al-Si, and the like, and stopper films therefor, which can each be typically formed into a thickness of 50 to 10,000 nm, particularly 100 to 5,000 nm. When the layer to be processed is formed, the substrate and the layer to be processed are made of different materials.

The present invention also provides a patterning process for forming a pattern in a substrate to be processed, including the steps of:
(II-1) forming a resist underlayer film on a substrate to be processed having a step by the inventive method for forming a resist underlayer film;
(II-2) forming a resist upper layer film on the resist underlayer film;
(II-3) subjecting the resist upper layer film to pattern exposure and then development with a developer to form a pattern in the resist upper layer film;
(II-4) transferring the pattern to the resist underlayer film by dry etching while using the resist upper layer film having the formed pattern as a mask; and
(II-5) processing the substrate to be processed while using the resist underlayer film having the formed pattern as a mask to form the pattern in the substrate to be processed.

Between the resist underlayer film and the resist layer thereon, an organic underlayer film, a silicon-containing film, an inorganic hard mask, an organic antireflective film (BARC), an adhesive film, or the like may be laminated.

It is preferable to include the steps of: filling the substrate to be processed having the step with the resist underlayer film; transferring the fine pattern (e.g. a pattern formed by a multi-patterning technology such as SADP and SAQP) formed on a layer above the resist underlayer film to the hard mask directly above the resist underlayer film; transferring the hard mask pattern to the resist underlayer film; and transferring the resist underlayer film pattern to the substrate to be processed.

The materials, film thickness, formation method, etc. for the organic underlayer film, silicon-containing film, inorganic hard mask, organic antireflective film (BARC), adhesive film, and substrate to be processed are as described above.

The inventive method for forming a resist underlayer film allows excellent properties of filling and planarizing a substrate to be processed having a step, and also allows excellent etching resistance at the time of the etching of the substrate to be processed, and is therefore effective for the above-described patterning process.

### EXAMPLES

The present invention is further specifically described below with reference to Synthesis Examples, Examples, and Comparative Examples. However, the present invention is not limited to these Examples. To obtain molecular weight and dispersity, weight-average molecular weight (Mw) and number-average molecular weight (Mn) on polystyrene basis were measured by gel permeation chromatography (GPC) using tetrahydrofuran as an eluent, and dispersity (Mw/Mn) was calculated from these values.

For the synthesis of the polymers (A1) to (A11) and the comparative compounds (R1) to (R5), the compounds (G1) to (G10) shown below were used.

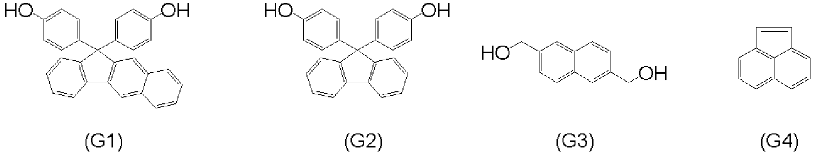

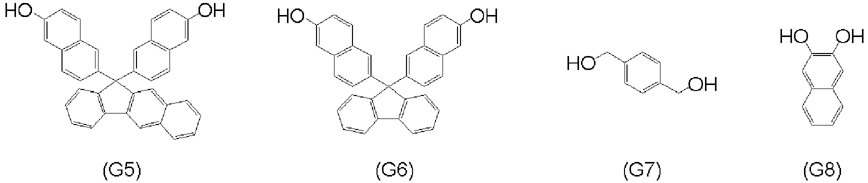

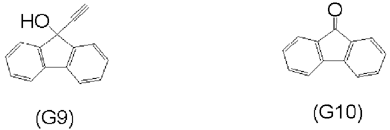

### Synthesis Examples: Synthesis of Polymer (A)

### [Synthesis Example 1] Synthesis of Polymer (A1)

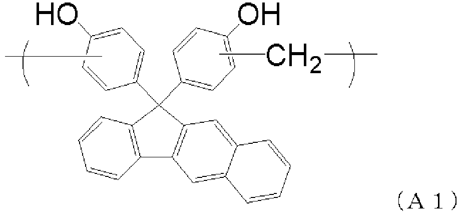

Under a nitrogen atmosphere, 100.0 g of the compound (G1), 14.7 g of a 92% formaldehyde, 5.0 g of para-toluenesulfonic acid, and 200 g of ethylene glycol were added together and then stirred at an internal temperature of 140°C for 8 hours. After cooling to room temperature, 500 g of methyl isobutyl ketone was added thereto. The organic layer was washed five times with 200 g of pure water, and then the organic layer was evaporated under reduced pressure to dryness. To the residue, 300 g of THF was added, and the polymer was reprecipitated in 1200 g of hexane. The precipitated polymer was separated by filtration and dried under reduced pressure to obtain a polymer (A1).

The weight-average molecular weight (Mw) and the dispersity (Mw/Mn) were determined by GPC, and the following results were obtained.

### (A1): Mw=5,610, Mw/Mn=3.60

### [Synthesis Example 2] Synthesis of Polymer (A2)

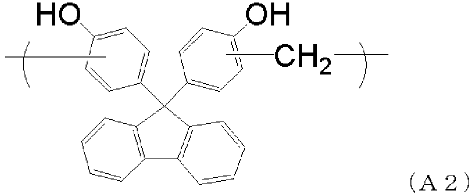

Under a nitrogen atmosphere, 180 g of the compound (G2), 75 g of a 37% formalin solution, and 5 g of oxalic acid were added together and then stirred at an internal temperature of 100°C for 24 hours. After cooling to room temperature, 500 g of methyl isobutyl ketone was added thereto. The organic layer was washed five times with 200 g of pure water, and then the organic layer was evaporated under reduced pressure to dryness. To the residue, 320 g of THF was added, and the polymer was reprecipitated in 1350 g of hexane. The precipitated polymer was separated by filtration and dried under reduced pressure to obtain a polymer (A2).

The weight-average molecular weight (Mw) and the dispersity (Mw/Mn) were determined by GPC, and the following results were obtained.

### (A2): Mw=11,200, Mw/Mn=4.35

### [Synthesis Example 3] Synthesis of Polymer (A3)

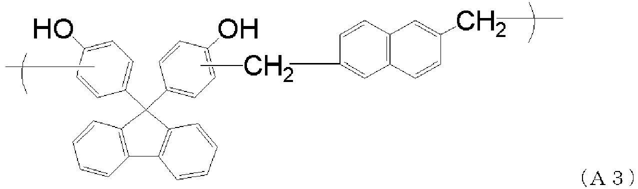

Under a nitrogen atmosphere, 100.0 g of the compound (G2), 48.3 g of the compound (G3), and 450 g of 1,2-dichloroethane were mixed together and then homogeneously dispersed at an internal temperature of 60°C. Subsequently, 82.4 g of methanesulfonic acid was added dropwise thereto over 1 hour, and the mixture was heated and stirred at an internal temperature of 70°C for 24 hours. After cooling to room temperature, 1000 g of methyl isobutyl ketone was added thereto. The organic layer was washed five times with 200 g of pure water, and then the organic layer was evaporated under reduced pressure to dryness. To the residue, 450 g of THF was added, and the polymer was reprecipitated in 1800 g of hexane. The precipitated polymer was separated by filtration and dried under reduced pressure to obtain a polymer (A3).

The weight-average molecular weight (Mw) and the dispersity (Mw/Mn) were determined by GPC, and the following results were obtained.

### (A3): Mw=9,800, Mw/Mn=3.50

### [Synthesis Example 4] Synthesis of Polymer (A4)

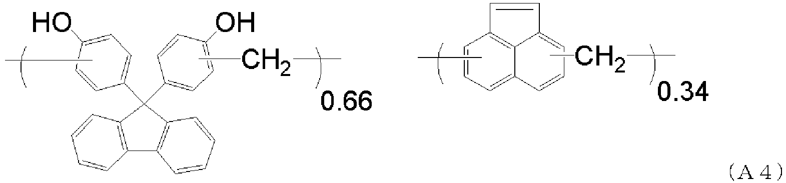

Under a nitrogen atmosphere, 180.0 g of the compound (G2), 58.0 g of the compound (G4), 75.0 g of a 37% formalin solution, 5.0 g of oxalic acid, and 500 g of 2-methoxy-1-propanol were added together and then stirred at an internal temperature of 100°C for 24 hours. After cooling to room temperature, 1000 g of methyl isobutyl ketone was added thereto. The organic layer was washed five times with 200 g of pure water, and then the organic layer was evaporated under reduced pressure to dryness. To the residue, 480 g of THF was added, and the polymer was reprecipitated in 2400 g of hexane. The precipitated polymer was separated by filtration and dried under reduced pressure to obtain a polymer (A4).

The weight-average molecular weight (Mw) and the dispersity (Mw/Mn) were determined by GPC, and the following results were obtained.

### (A4): Mw=9,350, Mw/Mn=3.76

### [Synthesis Example 5] Synthesis of Polymer (A5)

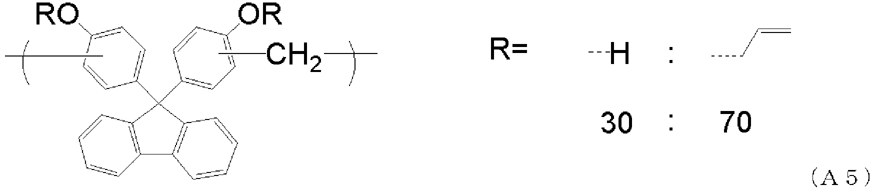

Under a nitrogen atmosphere, 50.0 g of the compound (A2) obtained in Synthesis Example 2, 38.1 g of potassium carbonate, and 200 g of dimethylformamide were added together to form a homogeneous dispersion at 50°C. Subsequently, 23.4 g of allyl bromide was slowly added dropwise thereto, and the mixture was stirred at an internal temperature of 50°C for 8 hours. The reaction solution was cooled to room temperature, and 400 ml of methyl isobutyl ketone and 300 g of pure water were added thereto. The precipitated salt was dissolved, and then the separated aqueous layer was removed. Furthermore, the organic layer was washed six times with 100 g of a 3% aqueous solution of nitric acid and 100 g of pure water, and then the organic layer was evaporated under reduced pressure to dryness to obtain a polymer (A5) .

The weight-average molecular weight (Mw) and the dispersity (Mw/Mn) were determined by GPC, and the following results were obtained.

### (A5): Mw=12,200, Mw/Mn=4.38

### [Synthesis Example 6] Synthesis of Polymer (A6)

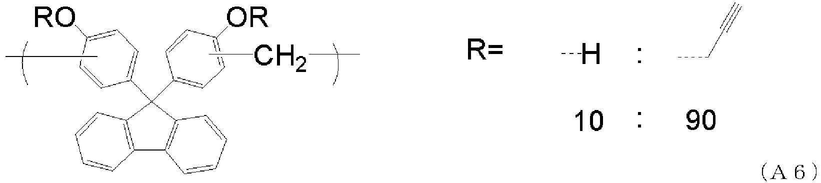

Under a nitrogen atmosphere, 50.0 g of the compound (A2) obtained in Synthesis Example 2, 41.9 g of potassium carbonate, and 200 g of dimethylformamide were added together to form a homogeneous dispersion at 50°C. Subsequently, 29.5 g of 3-bromo-1-propyne was slowly added dropwise thereto, and the mixture was stirred at an internal temperature of 50°C for 8 hours. The reaction solution was cooled to room temperature, and 400 ml of methyl isobutyl ketone and 300 g of pure water were added thereto. The precipitated salt was dissolved, and then the separated aqueous layer was removed. Furthermore, the organic layer was washed six times with 100 g of a 3% aqueous solution of nitric acid and 100 g of pure water, and then the organic layer was evaporated under reduced pressure to dryness to obtain a polymer (A6).

The weight-average molecular weight (Mw) and the dispersity (Mw/Mn) were determined by GPC, and the following results were obtained.

### (A6): Mw=12,800, Mw/Mn=4.43

### [Synthesis Example 7] Synthesis of Polymer (A7)

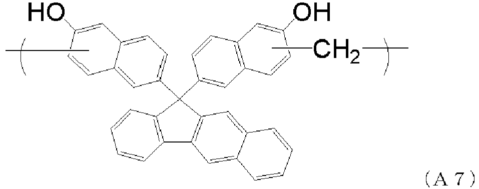

Under a nitrogen atmosphere, 100.0 g of the compound (G5), 24.3 g of a 37% formalin solution, and 300 g of 2-methoxy-1-propanol were added together to form a homogeneous solution at an internal temperature of 80°C. Subsequently, 25.0 g of a 20% solution of para-toluenesulfonic acid in 2-methoxy-1-propanol was slowly added thereto, and the mixture was stirred at an internal temperature of 110°C for 8 hours. After cooling to room temperature, 500 g of methyl isobutyl ketone was added thereto. The organic layer was washed five times with 200 g of pure water, and then the organic layer was evaporated under reduced pressure to dryness. To the residue, 300 g of THF was added, and the polymer was reprecipitated in 1500 g of methanol. The precipitated polymer was separated by filtration and dried under reduced pressure to obtain a polymer (A7).

The weight-average molecular weight (Mw) and the dispersity (Mw/Mn) were determined by GPC, and the following results were obtained.

### (A7): Mw=5,340, Mw/Mn=2.40

### [Synthesis Example 8] Synthesis of Polymer (A8)

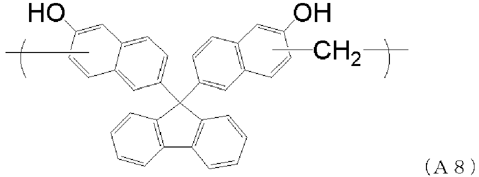

Under a nitrogen atmosphere, 90.1 g of the compound (G6), 25.2 g of a 37% formalin solution, and 270 g of 2-methoxy-1-propanol were added together to form a homogeneous solution at an internal temperature of 80°C. Subsequently, 18 g of a 20% solution of para-toluenesulfonic acid in 2-methoxy-1-propanol was slowly added thereto, and the mixture was stirred at an internal temperature of 110°C for 8 hours. After cooling to room temperature, 600 g of methyl isobutyl ketone was added thereto. The organic layer was washed five times with 200 g of pure water, and then the organic layer was evaporated under reduced pressure to dryness. To the residue, 320 g of THF was added, and the polymer was reprecipitated in 1350 g of methanol. The precipitated polymer was separated by filtration and dried under reduced pressure to obtain a polymer (A8).

The weight-average molecular weight (Mw) and the dispersity (Mw/Mn) were determined by GPC, and the following results were obtained.

### (A8): Mw=3,520, Mw/Mn=2.60

### [Synthesis Example 9] Synthesis of Polymer (A9)

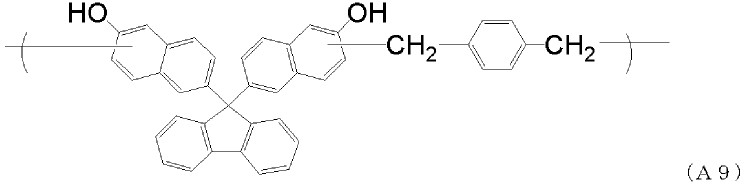

Under a nitrogen atmosphere, 100.0 g of the compound (G6), 24.5 g of the compound (G7), and 450 g of 1,2-dichloroethane were mixed together and homogeneously dispersed at an internal temperature of 60°C. Subsequently, 64.1 g of methanesulfonic acid was added dropwise thereto over 1 hour, and the mixture was heated and stirred at an internal temperature of 70°C for 24 hours. After cooling to room temperature, 1000 g of methyl isobutyl ketone was added thereto. The organic layer was washed five times with 200 g of pure water, and then the organic layer was evaporated under reduced pressure to dryness. To the residue, 450 g of THF was added, and the polymer was reprecipitated in 1300 g of methanol. The precipitated polymer was separated by filtration and dried under reduced pressure to obtain a polymer (A9).

The weight-average molecular weight (Mw) and the dispersity (Mw/Mn) were determined by GPC, and the following results were obtained.

### (A9): Mw=5,300, Mw/Mn=3.30

### [Synthesis Example 10] Synthesis of Polymer (A10)

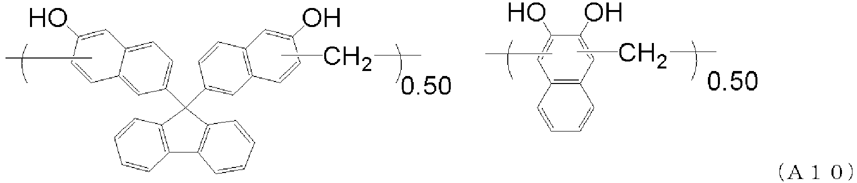

Under a nitrogen atmosphere, 50.0 g of the compound (G6), 17.8 g of the compound (G8), 3.0 g of para-toluenesulfonic acid, and 205 g of 2-methoxy-1-propanol were added together to form a homogeneous solution at an internal temperature of 100°C. Subsequently, 17.1 g of a 37% aqueous solution of formalin was slowly added dropwise thereto, and the mixture was stirred at an internal temperature of 110°C for 8 hours. After cooling to room temperature, 500 g of methyl isobutyl ketone was added thereto. The organic layer was washed five times with 100 g of pure water, and then the organic layer was evaporated under reduced pressure to dryness. To the residue, 210 g of THF was added, and the polymer was reprecipitated in 1260 g of hexane. The precipitated polymer was separated by filtration and dried under reduced pressure to obtain a polymer (A10).

The weight-average molecular weight (Mw) and the dispersity (Mw/Mn) were determined by GPC, and the following results were obtained.

### (A10): Mw=6,400, Mw/Mn=3.70

### [Synthesis Example 11] Synthesis of Polymer (A11)

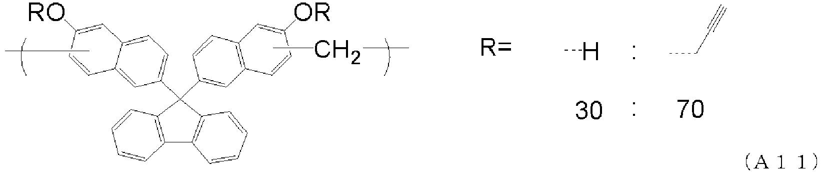

Under a nitrogen atmosphere, 50.0 g of the compound (A8) obtained in Synthesis Example 8, 29.9 g of potassium carbonate, and 200 g of dimethylformamide were added together to form a homogeneous dispersion at 50°C. Subsequently, 18.0 g of 3-bromo-1-propyne was slowly added dropwise thereto, and the mixture was stirred at an internal temperature of 50°C for 8 hours. The reaction solution was cooled to room temperature, and 300 ml of methyl isobutyl ketone and 200 g of pure water were added thereto. The precipitated salt was dissolved, and then the separated aqueous layer was removed. Furthermore, the organic layer was washed six times with 100 g of a 3% aqueous solution of nitric acid and 100 g of pure water, and then the organic layer was evaporated under reduced pressure to dryness to obtain a polymer (A11).

The weight-average molecular weight (Mw) and the dispersity (Mw/Mn) were determined by GPC, and the following results were obtained.

### (A11): Mw=4,400, Mw/Mn=4.10

### [Synthesis Example 12] Synthesis of Comparative Compound (R1)

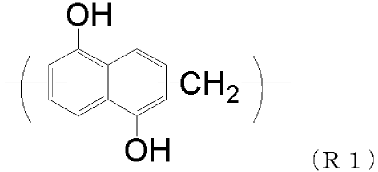

Under a nitrogen atmosphere, 160.2 g of 1,5-dihydroxynaphthalene, 64.9 g of a 37% formaldehyde solution, and 300 g of 2-methoxy-1-propanol were added together and homogenized at an internal temperature of 100°C. After that, 18.0 g of a 20% solution of para-toluenesulfonic acid in 2-methoxy-1-propanol, which had been mixed and homogenized beforehand, was slowly added thereto, and the reaction was allowed to take place at an internal temperature of 80°C for 8 hours. After the reaction was completed, the product was cooled to room temperature, 1000 ml of methyl isobutyl ketone was added thereto, the obtained product was washed six times with 200 ml of pure water, and the organic layer was evaporated under reduced pressure to dryness. To the residue, 300 g of THF was added to form a homogeneous solution, and a crystal was precipitated in 2000 g of hexane. The precipitated crystal was separated by filtration, washed twice with 500 g of hexane, and collected. The collected crystal was vacuum-dried at 70°C to obtain a polymer (R1).

The weight-average molecular weight (Mw) and the dispersity (Mw/Mn) were determined by GPC, and the following results were obtained.

### (R1): Mw=4,000, Mw/Mn=3.02

### [Synthesis Example 13] Synthesis of Comparative Compound (R2)

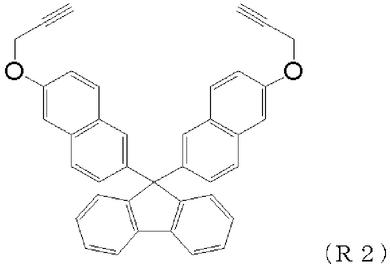

Under a nitrogen atmosphere, 42.8 g of the compound (G6), 15.7 g of potassium carbonate, and 150 g of DMF were added together to form a homogeneous dispersion at an internal temperature of 50°C. 28.2 g of 3-bromo-1-propyne was slowly added thereto, and the reaction was allowed to take place at an internal temperature of 50°C for 24 hours. To the reaction solution, 300 ml of methyl isobutyl ketone and 300 g of pure water were added. The precipitated salt was dissolved, and then the separated aqueous layer was removed. Furthermore, the organic layer was washed six times with 100 g of a 3% aqueous solution of nitric acid and 100 g of pure water, and then the organic layer was evaporated under reduced pressure to dryness to obtain a compound (R2).

The weight-average molecular weight (Mw) and the dispersity (Mw/Mn) were determined by GPC, and the following results were obtained.

### (R2): Mw=560, Mw/Mn=1.01

### [Synthesis Example 14] Synthesis of Comparative Compound (R3)

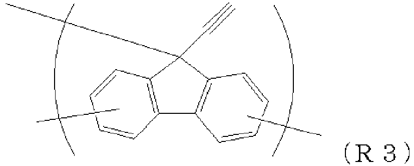

Under a nitrogen atmosphere, 41.2 g of the compound (G9) and 160 g of methylene chloride were mixed together. 19.2 g of methanesulfonic acid was slowly added dropwise thereto, and the reaction was allowed to take place by heating under reflux for 8 hours. After cooling to room temperature, 250 g of toluene was added thereto, and the organic layer was washed five times with 100 g of pure water. The organic layer was evaporated under reduced pressure to dryness to obtain a compound (R3).

The weight-average molecular weight (Mw) and the dispersity (Mw/Mn) were determined by GPC, and the following results were obtained.

### (R3): Mw=1850, Mw/Mn=1.26

### [Synthesis Example 15] Synthesis of Comparative Compound (R4)

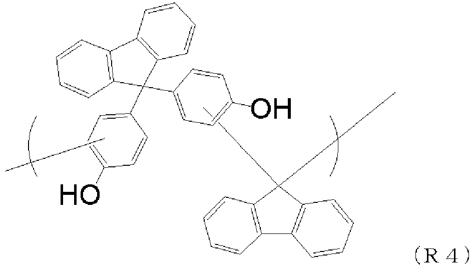

Under a nitrogen atmosphere, 230.0 g of the compound (G2), 20.0 g of the compound (G10), and 1040 g of dichloromethane were added together to form a homogeneous solution at an internal temperature of 35°C. Subsequently, 9.0 g of trifluoromethanesulfonic acid dissolved in 20.0 g of dichloromethane and 0.6 g of 3-mercaptopropionic acid were added thereto, and the reaction was allowed to take place for 4 hours by heating under reflux. After cooling to room temperature, the organic layer was washed five times with 300 g of pure water. The organic layer was evaporated under reduced pressure to dryness to obtain a compound (R4).

The weight-average molecular weight (Mw) and the dispersity (Mw/Mn) were determined by GPC, and the following results were obtained.

### (R4): Mw=680, Mw/Mn=1.26

### [Synthesis Example 16] Synthesis of Comparative Compound (R5)

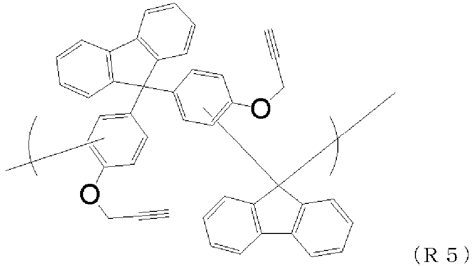

Under a nitrogen atmosphere, 20.0 g of the comparative compound (R4) obtained in Synthesis Example 15, 32.0 g of potassium carbonate, and 62.0 g of acetone were added together to form a homogeneous solution at 56°C. Subsequently, 28.0 g of 3-bromo-1-propyne was slowly added into the reaction vessel, and the mixture was stirred at 56°C for 3 hours. The product was cooled to room temperature, excessive potassium carbonate and salt were removed by filtration, and the precipitate was washed with acetone. The organic layer was washed five times with 300 g of pure water. The organic layer was evaporated under reduced pressure to dryness to obtain a compound (R5).

The weight-average molecular weight (Mw) and the dispersity (Mw/Mn) were determined by GPC, and the following results were obtained.

### (R5): Mw=1,040, Mw/Mn=1.38

### [Synthesis Example: Synthesis of Crosslinking Agent (C)]

### [Synthesis Example 17] Synthesis of Compound (C1)

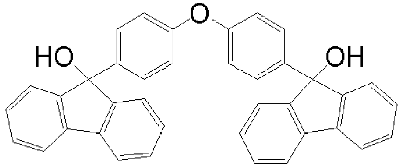

Under a nitrogen atmosphere, 500 mL of a 2.67 M hexane solution of n-butyllithium was added to a mixed solution of 219.0 g of bis(4-bromophenyl) ether and 750 g of t-butylmethyl ether, which had been cooled to have an internal temperature of -20°C, and the mixture was stirred at an internal temperature of -20°C for 20 minutes. 229.0 g of 9-fluorenone was added thereto, the temperature was gradually raised to room temperature, and the obtained mixture was stirred at room temperature for 4 hours. 500 g of pure water was added to terminate the reaction, and then the separated aqueous layer was removed. Furthermore, the organic layer was washed five times with 300 g of pure water, then the organic layer was concentrated under reduced pressure, and 1000 g of hexane was added thereto to precipitate a crystal. The precipitated crystal was separated by filtration, washed twice with 500 g of hexane, and collected. Then, the crystal was dried under reduced pressure to obtain a compound (C1).

### (C1): Mw=540, Mw/Mn=1.02

### [Composition (UDL-1) for Forming Resist Underlayer Film]

The polymer (A1) for forming a resist underlayer film was dissolved at a ratio shown in Table 2 in propylene glycol monomethyl ether acetate (PGMEA) containing 0.5 mass% of a surfactant FC-4430 (available from Sumitomo 3M Limited), and the obtained solution was filtered through a 0.02-µm membrane filter to prepare a composition (UDL-1) for forming a resist underlayer film.

### [Preparation of Compositions (UDL-2 to -15) for Forming Resist Underlayer Film and Comparative Compositions (Comparative UDL-1 to -5) for Forming Resist Underlayer Film]

Each chemical solution was prepared in the same manner as UDL-1, except that the kind and the contained amount of each component were as shown in Table 2. In Table 2, "-" indicates that the component was not used. The compound (C1), synthesized in Synthesis Example 17, and the following formula (C2) were used for the crosslinking agent, the following formula (E1) was used for the acid generator (TAG), the following formula (B1) was used for the high-boiling-point solvent, and the following formula (BP1) was used for the blend polymer.

### [Crosslinking Agent]

The crosslinking agents used in compositions for forming a resist underlayer film are shown below.

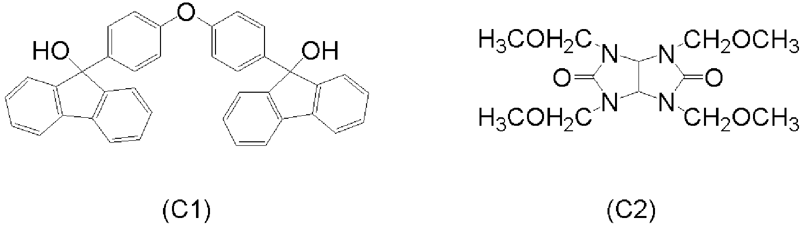

### [Acid Generator]

The thermal acid generator (E1) used in compositions for forming a resist underlayer film is shown below.

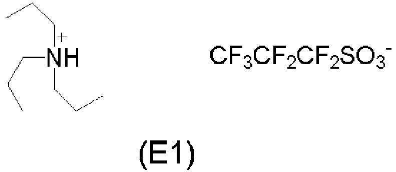

### [High-Boiling-Point Solvent]

The high-boiling-point solvent (B1) used in a composition for forming a resist underlayer film is shown in Table 1.

**[Table 1]**

| Compound | Mw (calculated value) | Weight reduction rate on heating from 30°C to 190°C | Weight reduction rate on heating from 30°C to 350°C |
|---|---|---|---|
| 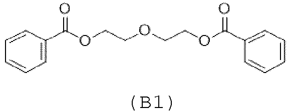 | 314 | 1 | 100 |

### [Blend Polymer]

The blend polymer (BP1) used in a composition for forming a resist underlayer film is shown below.

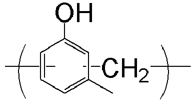

### (BP1): Mw=9,300, Mw/Mn=3.30

**[Table 2]**

| Composition for forming resist underlayer film | Polymer | Crosslinking agent | Additive /high-boiling-point solvent | Solvent |
|---|---|---|---|---|
| | (parts by mass) | (parts by mass) | (parts by mass) | (parts by mass) |
| UDL-1 | A1 (5) | - | - | PGMEA (95) |
| UDL-2 | A2 (5) | - | - | PGMEA (95) |
| UDL-3 | A3 (5) | - | - | PGMEA (95) |
| UDL-4 | A4 (5) | - | - | PGMEA (95) |
| UDL-5 | A5 (5) | - | - | PGMEA (95) |
| UDL-6 | A6 (5) | - | - | PGMEA (95) |
| UDL-7 | A7 (5) | - | - | PGMEA (95) |
| UDL-8 | A8 (5) | - | - | PGMEA (95) |
| UDL-9 | A9 (5) | - | - | PGMEA (95) |
| UDL-10 | A10 (5) | - | - | PGMEA (95) |
| UDL-11 | A11 (5) | - | - | PGMEA (95) |
| UDL-12 | A2 (5) | C1 (1) | E1 (0.2) | PGMEA (95) |
| UDL-13 | A2 (5) | C2 (1) | E1 (0.2) | PGMEA (95) |
| UDL-14 | A2 (5) | - | B1 (3) | PGMEA (95) |
| UDL-15 | A2 (5) | - | BP1 (1) | PGMEA (95) |
| Comparative UDL-1 | R1 (15) | - | - | PGMEA (95) |
| Comparative UDL-2 | R2 (15) | - | - | PGMEA (95) |
| Comparative UDL-3 | R3 (15) | - | - | PGMEA (95) |
| Comparative UDL-4 | R4 (15) | - | - | PGMEA (95) |
| Comparative UDL-5 | R5 (15) | - | - | PGMEA (95) |

### [Example 1: Film Thickness Evaluation]

Each of the compositions (UDL-1 to -15 and comparative UDL-1 to -5) for forming a resist underlayer film prepared as described above was respectively applied onto a silicon substrate and baked at 250°C for 60 seconds. After that, the film thickness from the central portion to the peripheral portion of the substrate was measured and the average film thickness (a [nm]) was calculated.

In addition, separately from the above, substrates heated at 250°C for 60 seconds were prepared, and each substrate was subjected to plasma treatment under the conditions given below to form a resist underlayer film. Then, the film thickness from the central portion to the peripheral portion of the substrate was measured and the average film thickness (b [nm]) was calculated.

The change in the thickness of the resist underlayer film due to the plasma irradiation and the film thickness uniformity after the plasma irradiation were evaluated. Regarding the film thickness uniformity, the film thicknesses of 225 points of the 300-mm wafer from the central portion to the peripheral portion of the substrate were measured, and when the difference in film thickness between the maximum film thickness and the minimum film thickness out of the measured thicknesses was less than 3% of the average film thickness (b), the composition was evaluated as "very good", when 3% or more and less than 5%, "good", and when 5% or more, "poor".

### Additional Treatment Conditions (Plasma Treatment)

Each of the substrates heated at 250°C for 60 seconds was subjected to plasma treatment under the following conditions by using an etching apparatus Telius manufactured by Tokyo Electron Ltd.

### Plasma treatment conditions

Chamber pressure: 100 mT
RF-power (upper portion): 100 W
RF-power (lower portion): 3500 W
H₂ gas flow rate: 200 sccm
Time: 20 sec

The results are shown in Table 3.

**[Table 3]**

| Example | Composition for forming resist underlayer film | Film thickness a (nm) | Film thickness b (nm) | Change in film thickness between before and after plasma irradiation (nm) | Film thickness uniformity |
|---|---|---|---|---|---|
| | | 250°C | After plasma irradiation | | After plasma irradiation |
| Example 1-1 | UDL-1 | 121 | 114 | 7 | A |
| Example 1-2 | UDL-2 | 122 | 118 | 4 | A |
| Example 1-3 | UDL-3 | 120 | 115 | 5 | B |
| Example 1-4 | UDL-4 | 121 | 116 | 5 | B |
| Example 1-5 | UDL-5 | 123 | 117 | 6 | A |
| Example 1-6 | UDL-6 | 122 | 115 | 7 | A |
| Example 1-7 | UDL-7 | 125 | 118 | 7 | A |
| Example 1-8 | UDL-8 | 117 | 108 | 9 | A |
| Example 1-9 | UDL-9 | 119 | 112 | 7 | B |
| Example 1-10 | UDL-10 | 120 | 114 | 6 | B |
| Example 1-11 | UDL-11 | 118 | 111 | 7 | A |
| Example 1-12 | UDL-12 | 124 | 120 | 4 | A |
| Example 1-13 | UDL-13 | 125 | 122 | 3 | A |
| Example 1-14 | UDL-14 | 117 | 113 | 4 | A |
| Example 1-15 | UDL-15 | 127 | 121 | 6 | A |
| Comparative Example 1-1 | Comparative UDL-1 | 123 | 109 | 14 | B |
| Comparative Example 1-2 | Comparative UDL-2 | 114 | 89 | 25 | C |
| Comparative Example 1-3 | Comparative UDL-3 | 118 | 98 | 20 | C |
| Comparative Example 1-4 | Comparative UDL-4 | 115 | 89 | 26 | C |
| Comparative Example 1-5 | Comparative UDL-5 | 116 | 88 | 28 | C |

| | | | | | |
|---|---|---|---|---|---|
| * Film thickness uniformity: A...very good, B...good, C...poor | | | | | |

As shown in Table 3, the inventive methods (Examples 1-1 to 1-15) for forming a resist underlayer film achieved excellent results regarding the film thickness uniformity after the plasma irradiation. It is conjectured that in the polymers contained in the compositions for forming a resist underlayer film used in the present invention, a structure including a high-carbon-density fluorene skeleton was repeatedly bonded via a methylene group, and therefore, the polymers had a characteristic that the dissociation and recombination of the carbon bonds caused by the plasma irradiation were easily promoted, but since the polymers contained a methylene group and a crosslinking group structure containing an oxygen atom, the curability, denseness, and heat resistance of the resist underlayer film were improved, and the dispersion of solid components in the film due to plasma irradiation was successfully alleviated, so that the change in film thickness between before and after the plasma irradiation was small, and resist underlayer films that exhibit excellent film thickness uniformity were successfully formed. The film thickness uniformity was particularly excellent in Examples 1-1, 1-2, 1-5, 1-6, 1-7, 1-8, and 1-11, where compositions for forming a resist underlayer film, each containing a polymer in which the "k" in the formula (1) was 0, was used. It is conjectured that when the "k" in the formula (1) is 1, the flowability of the polymer can be enhanced, and therefore, such a case is effective for the enhancement of planarizing property, but from the viewpoint of curability, "k" is preferably 0.

On the other hand, in Comparative Example 1-1, the change in film thickness between before and after the plasma irradiation was greater than in the Examples. Meanwhile, in Comparative Examples 1-2 to 1-5, the difference in film thickness between before and after the plasma irradiation was great, and the film thickness uniformity of the resist underlayer films after the plasma irradiation was insufficient. It is thought that, in these Comparative Examples, since an oligomer or a compound containing no methylene groups was used, the curability of the resist underlayer film before the addition treatment was insufficient, so that not only the progress of the dissociation and recombination of carbon bonds but also the dispersion of the solid components in the film may have occurred actively. It is conjectured that, for this reason, the change in film thickness between before and after the plasma irradiation was great and the film thickness uniformity after the plasma irradiation was insufficient.

### [Example 2: Etching Resistance Evaluation]

Each of the compositions (UDL-1 to -15 and comparative UDL-1 to -5) for forming a resist underlayer film prepared as described above was respectively applied onto a silicon substrate and baked at 250°C for 60 seconds. After that, the film thickness from the central portion to the peripheral portion of the substrate was measured and the average film thickness (c [nm]) was calculated. Subsequently, etching was performed with CF₄ gas under the conditions given below by using an etching apparatus Telius manufactured by Tokyo Electron Ltd., and the film thickness "d" was measured. Then, the film thickness etched in 1 minute was calculated as an etching rate A (nm/min) from the film thickness etched (film thickness "c" - film thickness "d") by the CF₄ gas in the specified time. Table 4 shows the results.

In addition, separately from the above, substrates heated at 250°C for 60 seconds were prepared, each substrate was subjected to plasma treatment under the conditions given below to form a resist underlayer film, and the film thickness "e" was measured. Subsequently, etching was performed with CF₄ gas under the conditions given below by using an etching apparatus Telius manufactured by Tokyo Electron Ltd., and the film thickness "f" was measured. Then, the film thickness etched in 1 minute was calculated as an etching rate B (nm/min) from the film thickness etched (film thickness "e" - film thickness "f") by the CF₄ gas in the specified time. A smaller value of the etching rate indicates that the composition has better resistance to etching with the CF₄ gas.

The etching resistance of the films subjected to the additional treatment and that of the films baked at 250°C were compared, and the effect of the additional treatment on the improvement of etching resistance (etching rate A (nm/min) - etching rate B (nm/min)) was calculated.

The etching conditions were as shown below.

### Conditions of dry etching with CF₄ gas

Chamber pressure: 100 mT
RF-power (upper portion): 500 W
RF-power (lower portion): 400 W
CF₄ gas flow rate: 300 sccm
Time: 30 sec

As the additional treatment conditions (plasma irradiation), the same conditions as in Example 1 were applied.

**[Table 4]**

| Example | Composition for forming resist underlayer film | CF₄ etching rate (nm/min) | CF₄ etching rate (nm/min) | Rate of improvement (nm/min) from additional treatment |
|---|---|---|---|---|
| | | 250°C | After additional treatment | |
| Example 2-1 | UDL-1 | 78 | 55 | 23 |
| Example 2-2 | UDL-2 | 80 | 44 | 36 |
| Example 2-3 | UDL-3 | 82 | 54 | 28 |
| Example 2-4 | UDL-4 | 81 | 52 | 29 |
| Example 2-5 | UDL-5 | 80 | 47 | 33 |
| Example 2-6 | UDL-6 | 79 | 48 | 31 |
| Example 2-7 | UDL-7 | 77 | 53 | 24 |
| Example 2-8 | UDL-8 | 75 | 48 | 27 |
| Example 2-9 | UDL-9 | 78 | 54 | 24 |
| Example 2-10 | UDL-10 | 80 | 55 | 25 |
| Example 2-11 | UDL-11 | 76 | 50 | 26 |
| Example 2-12 | UDL-12 | 79 | 45 | 34 |
| Example 2-13 | UDL-13 | 79 | 44 | 35 |
| Example 2-14 | UDL-14 | 80 | 44 | 36 |
| Example 2-15 | UDL-15 | 83 | 49 | 34 |
| Comparative Example 2-1 | Comparative UDL-1 | 92 | 83 | 9 |
| Comparative Example 2-2 | Comparative UDL-2 | 76 | 66 | 10 |
| Comparative Example 2-3 | Comparative UDL-3 | 73 | 63 | 10 |
| Comparative Example 2-4 | Comparative UDL-4 | 76 | 69 | 7 |
| Comparative Example 2-5 | Comparative UDL-5 | 78 | 70 | 8 |

As shown in Table 4, according to the inventive methods (Examples 1-1 to 1-15) for forming a resist underlayer film, the dry etching resistance to CF₄ gas was greatly improved by the plasma irradiation. It is thought that, since the polymers contained in the compositions for forming a resist underlayer film used in the present invention were polymers containing a high-carbon-density fluorene skeleton in the repeating unit, carbon bonds of the resist underlayer films were dissociated and recombined by the plasma irradiation, so that a cured film having a diamond-like carbon structure was easily reconstructed, and excellent dry etching resistance was exhibited. In particular, the dry etching resistance was excellent in Examples 2-2, 2-5, 2-6, 2-8, and 2-11, where a polymer in which the "k" was 0 and the Ar₁ and Ar₂ were benzene in the formula (1) was used, and furthermore, in Example 2-2, where a polymer in which the n₁ was 0 and the R₂ was a hydrogen atom in the formula (1A) was used, a particularly excellent result was achieved. It is conjectured that, since the polymer (A2), used in Example 2-2, had a large proportion of fluorene skeletons contained in the repeating unit, the dissociation and recombination of the carbon bonds of the resist underlayer film caused by the plasma irradiation were easily promoted, and furthermore, since the proportion of the crosslinking groups (hydroxy groups and methylene) contained in the repeating unit was also large, the denseness of the resist underlayer film was further enhanced by the plasma irradiation, and excellent dry etching resistance was exhibited.

Regarding Comparative Example 2-1, it is conjectured that, since no fluorene skeletons were contained in the repeating unit of the polymer, the modification of the resist underlayer film performed by the plasma irradiation was insufficient. Regarding Comparative Example 2-2, it is conjectured that a fluorene skeleton was contained, but since a compound was used rather than a polymer, the curability of the resist underlayer film before the plasma irradiation was insufficient, and the solid components in the resist underlayer film dispersed at the same time as the dissociation and recombination of carbon bonds by the plasma irradiation, so that the film modification achieved by the plasma irradiation did not progress sufficiently. Regarding Comparative Example 2-3, it is conjectured that, although a polymer containing a fluorene skeleton was used, the structure did not contain a methylene group and the molecular weight was low, and therefore, the curability of the resist underlayer film before the plasma irradiation was insufficient, and the solid components in the resist underlayer film dispersed at the same time as the dissociation and recombination of carbon bonds by the plasma irradiation, so that the film modification achieved by the plasma irradiation did not progress sufficiently. Regarding Comparative Example 2-4 and Comparative Example 2-5, it is conjectured that, although a fluorene skeleton was contained, the structures did not contain a methylene group and the compounds were oligomers, and therefore, the curability of the resist underlayer film before the plasma irradiation was insufficient, and the solid components in the resist underlayer film dispersed at the same time as the dissociation and recombination of carbon bonds by the plasma irradiation, so that the film modification achieved by the plasma irradiation did not progress sufficiently.

From the above results, it can be said that, to achieve both high modification of the resist underlayer film by plasma irradiation and high film thickness uniformity, the structure having the fluorene skeleton and the methylene group is important, and a polymer in which structures containing a fluorene skeleton are linked via methylene groups is preferable.

### [Example 3: Flatness Evaluation]

Each of the compositions (UDL-1 to -15 and comparative UDL-1 to -5) for forming a resist underlayer film was respectively applied onto an SiO₂ wafer substrate having a dense line-and-space pattern (line width = 40 nm, line depth = 120 nm, distance between the centers of two adjacent lines = 80 nm), and baked at 250°C for 60 seconds to form a resist underlayer film having a film thickness of 100 nm. After that, a plasma irradiation treatment was performed in the same manner as in the above-described dry etching resistance evaluation.

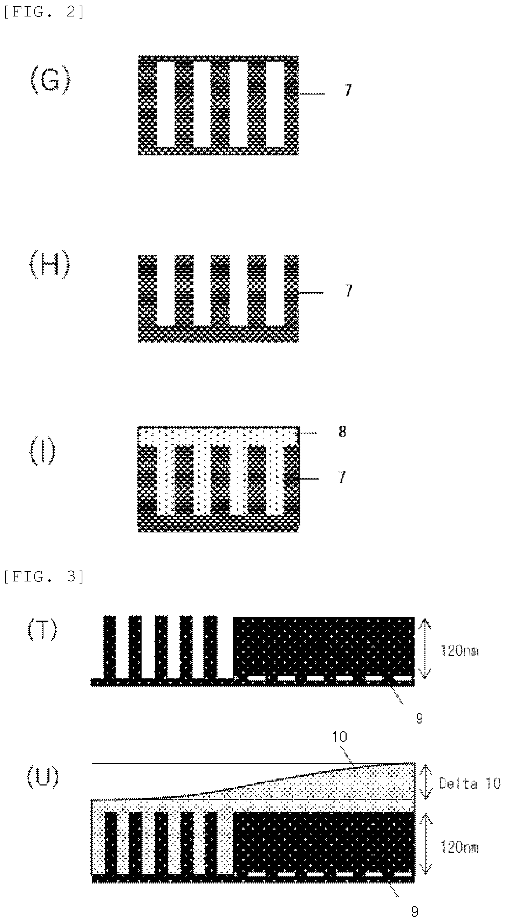

The substrate used was a base substrate 7 (SiO₂ wafer substrate) having a dense line-and-space pattern shown in FIG. 2 (G) (downward view) and (H) (cross-sectional view). As shown in FIG. 2 (I), the pattern is filled with a resist underlayer film 8. Subsequently, plasma irradiation treatment was performed, the cross-sectional shape of each of the obtained wafer substrates was observed using an electron microscope (S-4700: manufactured by Hitachi, Ltd.), and, as shown in FIG. 3 (T) and (U), the step Delta 10 of the resist underlayer film (filling film) 10 between the line-pattern-dense portion and the non-line-pattern portion of the base substrate 9 was evaluated. In the present evaluation, it can be said that the smaller the step, the better the planarizing property. Table 5 shows the results.

**[Table 5]**

| Example | Composition for forming resist underlayer film | Flatness |
|---|---|---|
| | | nm |
| Example 3-1 | UDL-1 | 43 |
| Example 3-2 | UDL-2 | 37 |
| Example 3-3 | UDL-3 | 34 |
| Example 3-4 | UDL-4 | 39 |
| Example 3-5 | UDL-5 | 35 |
| Example 3-6 | UDL-6 | 33 |
| Example 3-7 | UDL-7 | 47 |
| Example 3-8 | UDL-8 | 44 |
| Example 3-9 | UDL-9 | 41 |
| Example 3-10 | UDL-10 | 42 |
| Example 3-11 | UDL-11 | 42 |
| Example 3-12 | UDL-12 | 39 |
| Example 3-13 | UDL-13 | 38 |
| Example 3-14 | UDL-14 | 34 |
| Example 3-15 | UDL-15 | 35 |
| Comparative Example 3-1 | Comparative UDL-1 | 53 |
| Comparative Example 3-2 | Comparative UDL-2 | 51 |
| Comparative Example 3-3 | Comparative UDL-3 | 54 |
| Comparative Example 3-4 | Comparative UDL-4 | 55 |
| Comparative Example 3-5 | Comparative UDL-5 | 53 |

As shown in Table 5, it was successfully confirmed that the compositions (UDL-1 to -15) of the present invention for forming a resist underlayer film were capable of providing a resist underlayer film excellent in planarizing property even after plasma irradiation. On the other hand, in Comparative Examples 3-1 to 3-5, where comparative UDL-1 to -5, in which great change in film thickness between before and after the plasma irradiation was observed in Example 1, were used, it was observed that planarizing property was insufficient.

### [Example 4: Patterning Process]

Each of the compositions (UDL-1 to -15 and comparative UDL-1 to -5) for forming a resist underlayer film was respectively applied onto a silicon wafer substrate on which an SiO₂ film having a trench pattern (trench width: 10 um, trench depth: 0.10 µm) was formed, and baked at 250°C for 60 seconds in the atmosphere to form an underlayer-film-precursor film having a thickness of 100 nm. After that, a plasma irradiation treatment similar to that in the above-described dry etching resistance evaluation was performed.

Meanwhile, as Comparative Example 4-6, UDL-1 was applied onto a silicon wafer substrate on which an SiO₂ film was formed, and baked at 250°C for 60 seconds in the atmosphere to form a resist underlayer film having a thickness of 100 nm. This resist underlayer film was not subjected to plasma irradiation.

A silicon-containing resist middle layer film material (SOG-1) was applied onto the resist underlayer film prepared in the above-described manner, followed by baking at 220°C for 60 seconds to form a resist middle layer film having a thickness of 20 nm. A monolayer resist for ArF as a resist upper layer film material was applied thereto, followed by baking at 105°C for 60 seconds to form a photoresist film having a thickness of 100 nm. A liquid immersion top coat composition (TC-1) was applied to the photoresist film, followed by baking at 90°C for 60 seconds to form a top coat having a thickness of 50 nm.

The silicon-containing resist middle layer film composition (SOG-1) was prepared by dissolving an ArF silicon-containing middle layer film polymer represented by (SiP1) and a crosslinking catalyst (CAT1) in an organic solvent containing 0.1 mass% of FC-4430 (available from Sumitomo 3M Limited) in the proportion shown in Table 6; and filtering the solution through a filter made of a fluororesin and having a pore size of 0.1 µm.

**[Table 6]**

| | Polymer | Thermal crosslinking catalyst | Organic solvent |
|---|---|---|---|
| | (parts by mass) | (parts by mass) | (parts by mass) |
| SOG-1 | SiP1 (100) | CAT1 (1) | Propylene glycol monoethyl ether (4000) |

The structural formulae of the used ArF silicon-containing middle layer film polymer (SiP1) and crosslinking catalyst (CAT1) are shown below.

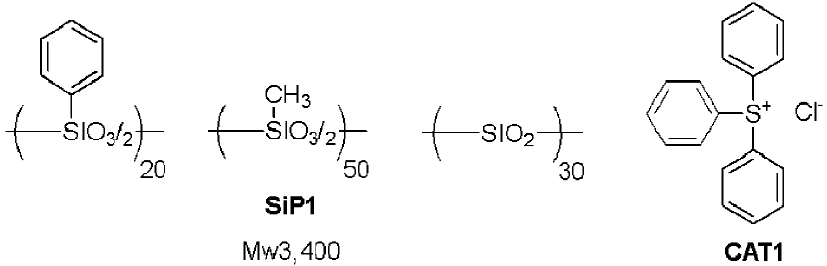

The resist upper layer film material (monolayer resist for ArF) was prepared by dissolving a polymer (RP1), an acid generator (PAG1), and a basic compound (Amine1), each in the proportion shown in Table 7, in a solvent containing 0.1% by mass of a surfactant FC-4430 (available from Sumitomo 3M Limited); and filtering the solution through a 0.1-pm filter made of a fluororesin.

**[Table 7]**

| | Polymer (parts by mass) | Acid generator (parts by mass) | Basic compound (parts by mass) | Solvent (parts by mass) |
|---|---|---|---|---|
| Monolayer resist for ArF | RP1 (100) | PAG1 (6.6) | Amine1 (0.8) | PGMEA (2500) |

The polymer (RP1), the acid generator (PAG1), and the basic compound (Amine1) used for the resist upper layer film material (monolayer resist for ArF) are shown below.

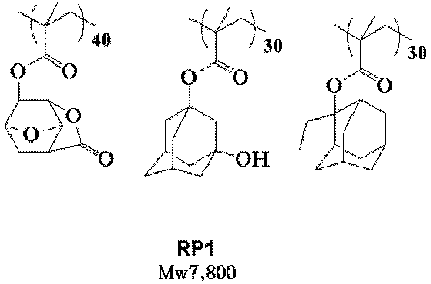

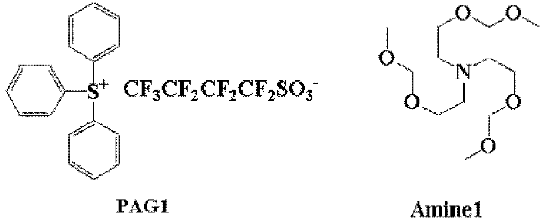

The liquid immersion top coat composition (TC-1) was prepared by dissolving a top coat polymer (PP1) in an organic solvent at the proportion shown in Table 8, and filtering the solution through a 0.1-pm filter made of a fluororesin.

**[Table 8]**

| | Polymer (parts by mass) | Organic solvent (parts by mass) |
|---|---|---|
| TC-1 | PP1 (100) | Diisoamyl ether (2700) |
| | | 2-methyl-1-butanol (270) |

The polymer (PP1) used for the liquid immersion top coat composition (TC-1) is shown below.

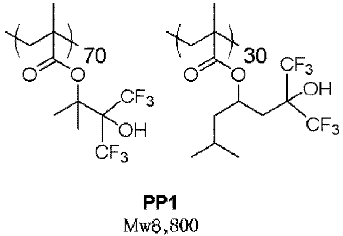

Then, the substrate was exposed to light with an ArF liquid immersion exposure apparatus (NSR-S610C manufactured by Nikon Corporation, NA: 1.30, σ: 0.98/0.78, 35° s-polarized dipole illumination, 6% halftone phase shift mask), baked at 100°C for 60 seconds (PEB), and developed with a 2.38% by mass aqueous solution of tetramethylammonium hydroxide (TMAH) for 30 seconds, thereby obtaining a 40 nm 1 : 1 positive line-and-space pattern (resist pattern).

Subsequently, the silicon-containing resist middle layer film material (SOG-1) was etched by dry etching by using an etching apparatus Telius manufactured by Tokyo Electron Ltd. while using the resist pattern as a mask to form a hard mask pattern. Then, the resist underlayer film was etched while using the obtained SOG-1 pattern as a mask to form a resist underlayer film pattern. Then, the SiO₂ film was etched while using the obtained resist underlayer film pattern as a mask. The etching conditions were as follows.

### Conditions in transferring resist pattern to silicon-containing resist middle layer film material (SOG-1)

Chamber pressure: 50 mT
RF-power (upper portion): 500 W
RF-power (lower portion): 300 W
CF₄ gas flow rate: 150 sccm
CHF₃ gas flow rate: 50 sccm
Time: 15 sec

### Conditions in transferring silicon-containing resist middle layer film material (SOG-1) pattern to resist underlayer film

Chamber pressure: 10 mT
RF-power (upper portion): 1,000 W
RF-power (lower portion): 300 W
CO₂ gas flow rate: 320 sccm
N₂ gas flow rate: 80 sccm
Time: 55 sec

### Conditions in transferring resist underlayer film pattern to SiO₂ film

Chamber pressure: 100 mT
RF-power (upper portion): 500 W
RF-power (lower portion): 300 W
CF₄ gas flow rate: 150 sccm
CHF₃ gas flow rate: 30 sccm
O₂ gas flow rate: 10 sccm
Time: 130 sec

Table 9 shows the results obtained by observing the cross section of the pattern with an electron microscope (S-4700) manufactured by Hitachi, Ltd.

**[Table 9]**

| Example | Composition for forming resist underlayer film | Whether or not plasma irradiation was performed | Pattern profile after etching for transferring pattern to substrate |
|---|---|---|---|
| Example 4-1 | UDL-1 | Yes | Vertical profile |
| Example 4-2 | UDL-2 | Yes | Vertical profile |
| Example 4-3 | UDL-3 | Yes | Vertical profile |
| Example 4-4 | UDL-4 | Yes | Vertical profile |
| Example 4-5 | UDL-5 | Yes | Vertical profile |
| Example 4-6 | UDL-6 | Yes | Vertical profile |
| Example 4-7 | UDL-7 | Yes | Vertical profile |
| Example 4-8 | UDL-8 | Yes | Vertical profile |
| Example 4-9 | UDL-9 | Yes | Vertical profile |
| Example 4-10 | UDL-10 | Yes | Vertical profile |
| Example 4-11 | UDL-11 | Yes | Vertical profile |
| Example 4-12 | UDL-12 | Yes | Vertical profile |
| Example 4-13 | UDL-13 | Yes | Vertical profile |
| Example 4-14 | UDL-14 | Yes | Vertical profile |
| Example 4-15 | UDL-15 | Yes | Vertical profile |
| Comparative Example 4-1 | Comparative UDL-1 | Yes | No pattern |
| Comparative Example 4-2 | Comparative UDL-2 | Yes | Distorted pattern |
| Comparative Example 4-3 | Comparative UDL-3 | Yes | Distorted pattern |
| Comparative Example 4-4 | Comparative UDL-4 | Yes | Distorted pattern |
| Comparative Example 4-5 | Comparative UDL-5 | Yes | Distorted pattern |
| Comparative Example 4-6 | UDL-1 | No | No pattern |

As shown in Table 9, in Examples 4-1 to 4-15, where the compositions (UDL-1 to -15) of the present invention for forming a resist underlayer film were used, the resist upper layer film pattern was desirably transferred to the substrate to be processed in the end in every case. It was thus confirmed that the inventive method for forming a resist underlayer film is suitably used for fine processing using the multilayer resist method. On the other hand, in Comparative Examples 4-2 to 4-5, using comparative UDL-2 to -5, which were found to have insufficient etching resistance in the above-described etching resistance evaluation compared to when the inventive method for forming a resist underlayer film was used, it was observed that the pattern profile after the etching to transfer the pattern to the substrate was distorted. Meanwhile, in Comparative Example 4-1, using comparative UDL-1, which had extremely insufficient etching resistance, and in Comparative Example 4-6, where plasma irradiation was not performed, no pattern remained, and it was observed that the pattern had not been transferred to the substrate to be processed due to the resist underlayer film having insufficient etching resistance.

As seen from the above, the inventive method for forming a resist underlayer film makes it possible to form, with excellent film thickness uniformity, a resist underlayer film that exhibits excellent dry etching resistance at the time of substrate processing by irradiation with plasma, and therefore, is significantly useful in next-generation fine processing. It was also revealed that the inventive patterning processes, using this method, makes it possible to form fine patterns with high accuracy even when a body to be processed is a substrate having a step.

The present description includes the following inventions.
[1]: A method for forming a resist underlayer film on a substrate, the method comprising the steps of:
   (i) forming an underlayer-film-precursor film by applying a composition for forming a resist underlayer film onto the substrate, the composition containing (A) a polymer and (B) an organic solvent, and subjecting the composition to heat treatment at a temperature of 100°C or higher and 800°C or lower for 10 seconds to 7,200 seconds to cure the composition; and
   (ii) forming a resist underlayer film by subjecting the substrate having the underlayer-film-precursor film formed to plasma irradiation,
   wherein the polymer (A) contains a constitutional unit represented by the following general formula (1) and has a weight-average molecular weight of 2,500 to 20,000 as measured by gel permeation chromatography in terms of polystyrene, 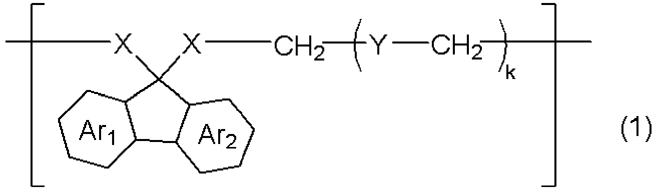 wherein Ar₁ and Ar₂ each independently represent a substituted or unsubstituted benzene ring or a substituted or unsubstituted naphthalene ring, X represents a structure represented by the following general formula (1A), Y represents a divalent organic group having 6 to 50 carbon atoms, and "k" represents 0 or 1, 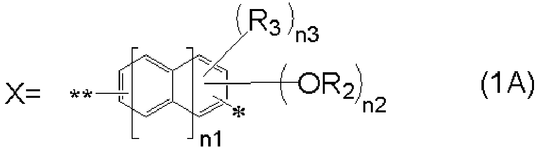 wherein "n₁" represents 0 or 1, "n₂" represents 1 or 2, R₂ represents a hydrogen atom or an organic group having 1 to 10 carbon atoms or has a structure represented by one of the following general formulae (1B), R₃ represents a hydrogen atom, a linear, branched, or cyclic alkyl group having 1 to 10 carbon atoms, an aryl group having 6 to 10 carbon atoms, or a group represented by the following general formula (1C), "ns" represents 0, 1, or 2, "*" represents an attachment point to the methylene group, and "**" represents an attachment point to the quaternary carbon atom of the fluorene, 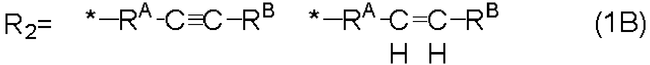 wherein "*" represents an attachment point to the oxygen atom, R^{A} represents a divalent organic group having 1 to 10 carbon atoms, and R^{B} represents a hydrogen atom or a monovalent organic group having 1 to 10 carbon atoms, 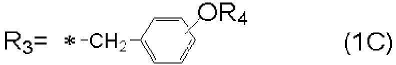 wherein R₄ represents a hydrogen atom or a saturated or unsaturated hydrocarbon group having 1 to 10 carbon atoms, a hydrogen atom on the benzene ring in the formula optionally being substituted with a methyl group or a methoxy group.
[2]: The method for forming a resist underlayer film according to the above [1], wherein the Y in the general formula (1) has a structure represented by any of the following formulae (Y-1), 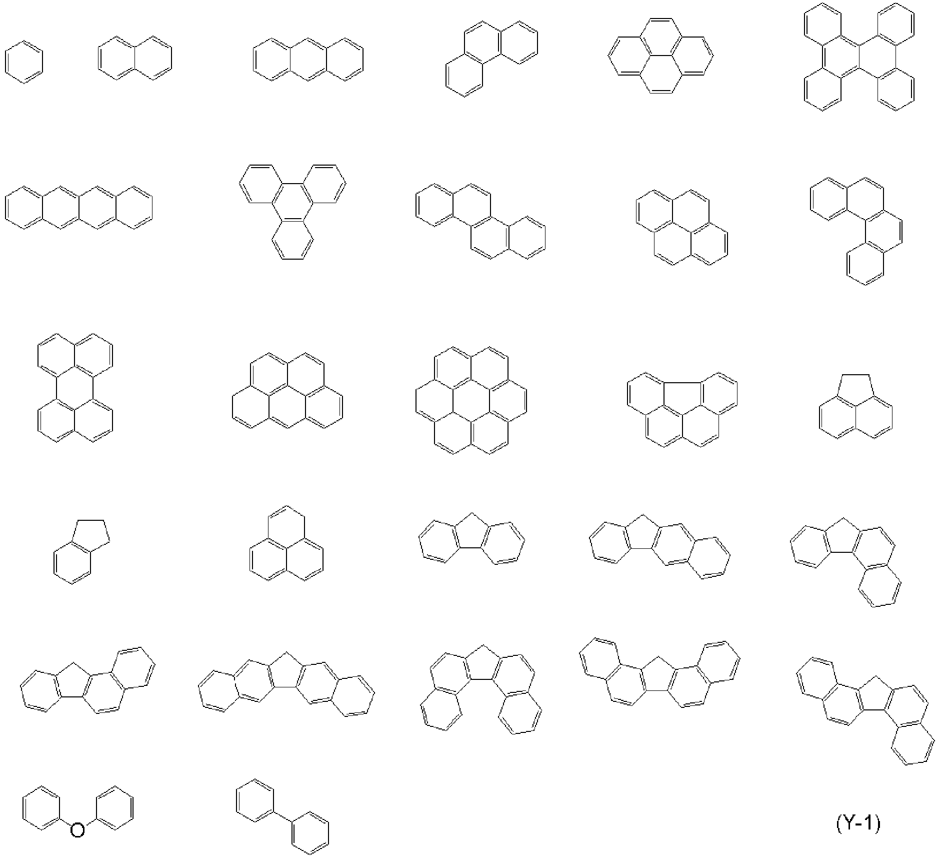 wherein a hydrogen atom of the structures is optionally substituted with a hydroxy group or a monovalent organic group having 1 to 10 carbon atoms.
[3]: The method for forming a resist underlayer film according to the above [1] or the above [2], wherein the R₂ in the general formula (1A) is a hydrogen atom.
[4]: The method for forming a resist underlayer film according to any one of the above [1] to [3], wherein the R₂ in the general formula (1A) is a hydrogen atom or has the structure represented by the general formula (1B), and in the structure constituting the R₂, a proportion "a" of hydrogen atoms and a proportion "b" of the structure represented by the general formula (1B) satisfy relationships a + b = 1 and 0.1 ≤ b ≤ 0.9.
[5]: The method for forming a resist underlayer film according to any one of the above [1] to [4], wherein the Ari and Ar₂ in the general formula (1) are each an unsubstituted benzene ring, and in the general formula (1A), "n1" is 0, "n2" is 1 or 2, and "n3" is 0.
[6]: The method for forming a resist underlayer film according to any one of the above [1] to [5], wherein the "k" in the general formula (1) is 0.
[7]: The method for forming a resist underlayer film according to any one of the above [1] to [6], wherein the polymer (A) has a weight-average molecular weight of 7000 to 15,000 as measured by gel permeation chromatography in terms of polystyrene.
[8]: The method for forming a resist underlayer film according to any one of the above [1] to [7], wherein the composition for forming a resist underlayer film further contains one or more of: (C) a crosslinking agent; (D) a surfactant; (E) an acid generator; and (F) a plasticizer.
[9]: The method for forming a resist underlayer film according to any one of the above [1] to [8], wherein the organic solvent (B) is a mixture of one or more kinds of organic solvent having a boiling point of lower than 180°C and one or more kinds of (B-1) a high-boiling-point solvent, being an organic solvent having a boiling point of 180°C or higher.
[10]: The method for forming a resist underlayer film according to any one of the above [1] to [9], wherein the plasma irradiation in the step (ii) is performed under an atmosphere of N₂, NF₃, H₂, fluorocarbon, a rare gas, or a mixture of any thereof.
[11]: The method for forming a resist underlayer film according to any one of the above [1] to [10], wherein the heat treatment in the step (i) is performed under an atmosphere with an oxygen concentration of 1% or more and 21% or less.
[12]: The method for forming a resist underlayer film according to any one of the above [1] to [10], wherein the heat treatment in the step (i) is performed under an atmosphere with an oxygen concentration of less than 1%.
[13]: A patterning process for forming a pattern in a substrate to be processed, comprising the steps of:
   (I-1) forming a resist underlayer film on a substrate to be processed by the method for forming a resist underlayer film according to any one of the above [1] to [12];
   (I-2) forming a resist middle layer film on the resist underlayer film;
   (I-3) forming a resist upper layer film on the resist middle layer film by using a photoresist material;
   (I-4) subjecting the resist upper layer film to pattern exposure and then development with a developer to form a pattern in the resist upper layer film;
   (I-5) transferring the pattern to the resist middle layer film by dry etching while using the resist upper layer film having the formed pattern as a mask;
   (I-6) transferring the pattern to the resist underlayer film by dry etching while using the resist middle layer film having the transferred pattern as a mask; and
   (I-7) processing the substrate to be processed while using the resist underlayer film having the formed pattern as a mask to form the pattern in the substrate to be processed.
[14]: A patterning process for forming a pattern in a substrate to be processed, comprising the steps of:
   (II-1) forming a resist underlayer film on a substrate to be processed having a step by the method for forming a resist underlayer film according to any one of the above [1] to [12];
   (II-2) forming a resist upper layer film on the resist underlayer film;
   (II-3) subjecting the resist upper layer film to pattern exposure and then development with a developer to form a pattern in the resist upper layer film;
   (II-4) transferring the pattern to the resist underlayer film by dry etching while using the resist upper layer film having the formed pattern as a mask; and
   (II-5) processing the substrate to be processed while using the resist underlayer film having the formed pattern as a mask to form the pattern in the substrate to be processed.
[15]: The patterning process according to the above [13] or [14], wherein the step of the substrate to be processed has an aspect ratio of 3 or higher.

It should be noted that the present invention is not limited to the above-described embodiments. The embodiments are just examples, and any examples that have substantially the same feature and demonstrate the same functions and effects as those in the technical concept disclosed in claims of the present invention are included in the technical scope of the present invention.

## Claims

1. A method for forming a resist underlayer film on a substrate, the method comprising the steps of:
(i) forming an underlayer-film-precursor film by applying a composition for forming a resist underlayer film onto the substrate, the composition containing (A) a polymer and (B) an organic solvent, and subjecting the composition to heat treatment at a temperature of 100°C or higher and 800°C or lower for 10 seconds to 7,200 seconds to cure the composition; and
(ii) forming a resist underlayer film by subjecting the substrate having the underlayer-film-precursor film formed to plasma irradiation,
wherein the polymer (A) contains a constitutional unit represented by the following general formula (1) and has a weight-average molecular weight of 2,500 to 20,000 as measured by gel permeation chromatography in terms of polystyrene, 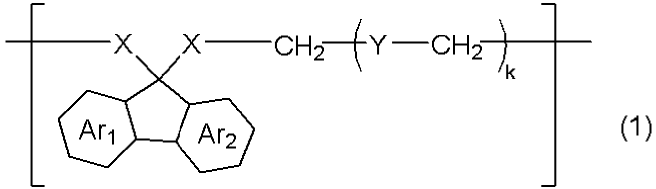 wherein Ar₁ and Ar₂ each independently represent a substituted or unsubstituted benzene ring or a substituted or unsubstituted naphthalene ring, X represents a structure represented by the following general formula (1A), Y represents a divalent organic group having 6 to 50 carbon atoms, and "k" represents 0 or 1, 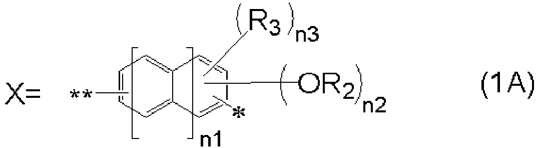 wherein "n₁" represents 0 or 1, "n₂" represents 1 or 2, R₂ represents a hydrogen atom or an organic group having 1 to 10 carbon atoms or has a structure represented by one of the following general formulae (1B), R₃ represents a hydrogen atom, a linear, branched, or cyclic alkyl group having 1 to 10 carbon atoms, an aryl group having 6 to 10 carbon atoms, or a group represented by the following general formula (1C), "ns" represents 0, 1, or 2, "*" represents an attachment point to the methylene group, and "**" represents an attachment point to the quaternary carbon atom of the fluorene, 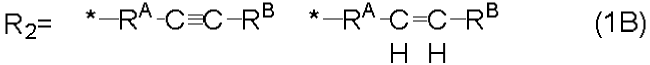 wherein "*" represents an attachment point to the oxygen atom, R^{A} represents a divalent organic group having 1 to 10 carbon atoms, and R^{B} represents a hydrogen atom or a monovalent organic group having 1 to 10 carbon atoms, 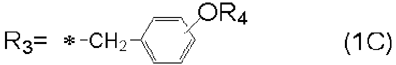 wherein R₄ represents a hydrogen atom or a saturated or unsaturated hydrocarbon group having 1 to 10 carbon atoms, a hydrogen atom on the benzene ring in the formula optionally being substituted with a methyl group or a methoxy group.

2. The method for forming a resist underlayer film according to claim 1, wherein the Y in the general formula (1) has a structure represented by any of the following formulae (Y-1), 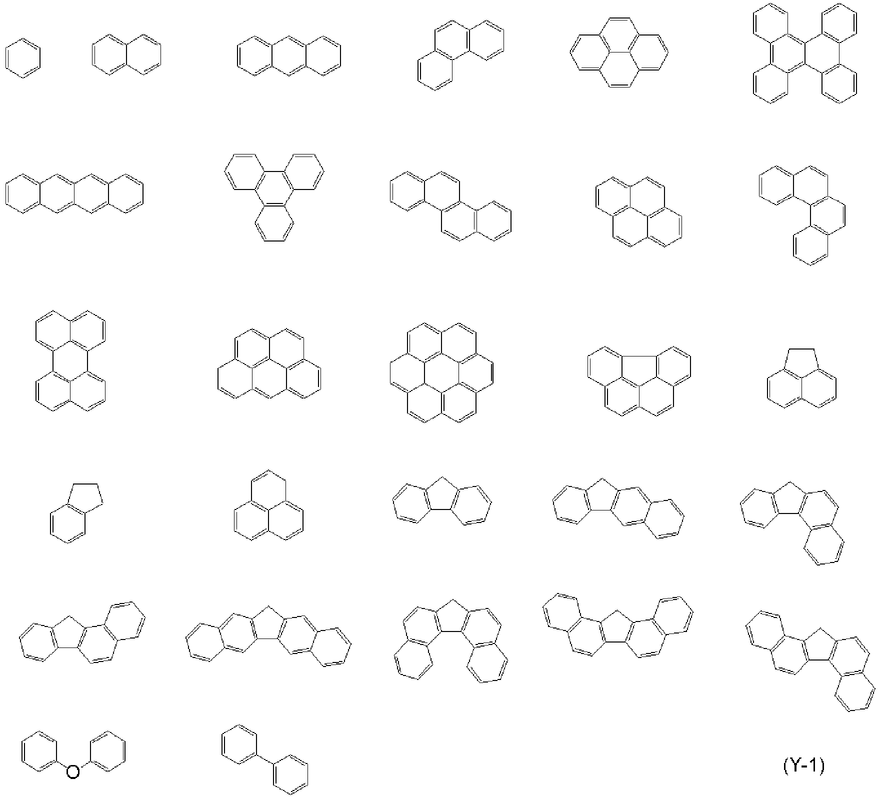 wherein a hydrogen atom of the structures is optionally substituted with a hydroxy group or a monovalent organic group having 1 to 10 carbon atoms.

3. The method for forming a resist underlayer film according to claim 1, wherein the R₂ in the general formula (1A) is a hydrogen atom.

4. The method for forming a resist underlayer film according to claim 1, wherein the R₂ in the general formula (1A) is a hydrogen atom or has the structure represented by the general formula (1B), and in the structure constituting the R₂, a proportion "a" of hydrogen atoms and a proportion "b" of the structure represented by the general formula (1B) satisfy relationships a + b = 1 and 0.1 ≤ b ≤ 0.9.

5. The method for forming a resist underlayer film according to claim 1, wherein the Ar₁ and Ar₂ in the general formula (1) are each an unsubstituted benzene ring, and in the general formula (1A), "n1" is 0, "n2" is 1 or 2, and "n3" is 0.

6. The method for forming a resist underlayer film according to claim 1, wherein the "k" in the general formula (1) is 0.

7. The method for forming a resist underlayer film according to claim 1, wherein the polymer (A) has a weight-average molecular weight of 7000 to 15,000 as measured by gel permeation chromatography in terms of polystyrene.

8. The method for forming a resist underlayer film according to claim 1, wherein the composition for forming a resist underlayer film further contains one or more of: (C) a crosslinking agent; (D) a surfactant; (E) an acid generator; and (F) a plasticizer.

9. The method for forming a resist underlayer film according to claim 1, wherein the organic solvent (B) is a mixture of one or more kinds of organic solvent having a boiling point of lower than 180°C and one or more kinds of (B-1) a high-boiling-point solvent, being an organic solvent having a boiling point of 180°C or higher.

10. The method for forming a resist underlayer film according to any one of claims 1 to 9, wherein the plasma irradiation in the step (ii) is performed under an atmosphere of N₂, NF₃, H₂, fluorocarbon, a rare gas, or a mixture of any thereof.

11. The method for forming a resist underlayer film according to any one of claims 1 to 9, wherein the heat treatment in the step (i) is performed under an atmosphere with an oxygen concentration of 1% or more and 21% or less.

12. The method for forming a resist underlayer film according to any one of claims 1 to 9, wherein the heat treatment in the step (i) is performed under an atmosphere with an oxygen concentration of less than 1%.

13. A patterning process for forming a pattern in a substrate to be processed, comprising the steps of:
(I-1) forming a resist underlayer film on a substrate to be processed by the method for forming a resist underlayer film according to any one of claims 1 to 9;
(I-2) forming a resist middle layer film on the resist underlayer film;
(I-3) forming a resist upper layer film on the resist middle layer film by using a photoresist material;
(I-4) subjecting the resist upper layer film to pattern exposure and then development with a developer to form a pattern in the resist upper layer film;
(I-5) transferring the pattern to the resist middle layer film by dry etching while using the resist upper layer film having the formed pattern as a mask;
(I-6) transferring the pattern to the resist underlayer film by dry etching while using the resist middle layer film having the transferred pattern as a mask; and
(I-7) processing the substrate to be processed while using the resist underlayer film having the formed pattern as a mask to form the pattern in the substrate to be processed.

14. A patterning process for forming a pattern in a substrate to be processed, comprising the steps of:
(II-1) forming a resist underlayer film on a substrate to be processed having a step by the method for forming a resist underlayer film according to any one of claims 1 to 9;
(II-2) forming a resist upper layer film on the resist underlayer film;
(II-3) subjecting the resist upper layer film to pattern exposure and then development with a developer to form a pattern in the resist upper layer film;
(II-4) transferring the pattern to the resist underlayer film by dry etching while using the resist upper layer film having the formed pattern as a mask; and
(II-5) processing the substrate to be processed while using the resist underlayer film having the formed pattern as a mask to form the pattern in the substrate to be processed.

15. The patterning process according to claim 14, wherein the step of the substrate to be processed has an aspect ratio of 3 or higher.
